(19) Europäisches Patentamt
European Patent Office
Office européen des brevets

(11) **EP 4 432 561 A1**

(12) **EUROPEAN PATENT APPLICATION**
published in accordance with Art. 153(4) EPC

(43) Date of publication:
**18.09.2024 Bulletin 2024/38**

(21) Application number: **22889983.7**

(22) Date of filing: **02.11.2022**

(51) International Patent Classification (IPC):
**H03H 7/075** (2006.01)   **H01F 37/00** (2006.01)
**H03H 7/06** (2006.01)

(52) Cooperative Patent Classification (CPC):
**H01F 37/00; H03H 7/06; H03H 7/075**

(86) International application number:
**PCT/JP2022/041015**

(87) International publication number:
**WO 2023/080163 (11.05.2023 Gazette 2023/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **08.11.2021 JP 2021181673**

(71) Applicant: **Ube Machinery Corporation, Ltd.
Ube-shi, Yamaguchi 755-8633 (JP)**

(72) Inventor: **TAKII, Takashi
Nagoya-shi, Aichi 455-0024 (JP)**

(74) Representative: **Cabinet Beau de Loménie
158, rue de l'Université
75340 Paris Cedex 07 (FR)**

(54) **NOISE FILTER AND ELECTRIC CIRCUIT**

(57) A noise filter in the present invention includes: a first conductive member 51A and a second conductive member 51B that constitute a transmission line; a third conductive member 55A that is disposed with a first intermediate member 53A between the first conductive member 51A and the third conductive member 55A; a fourth conductive member 55B that is disposed with a second intermediate member 53B between the second conductive member 51B and the fourth conductive member 55B; a first resistance member 65A and a second resistance member 65B that electrically join the third con-ductive member 55A and the fourth conductive member 55B; and a first magnetic path 57 that is formed in a region between the third conductive member 55A and the fourth conductive member 55B, in which one or both of the first intermediate member 53A and the second intermediate member 53B is an insulator, and the third conductive member 55A, the first resistance member 65A, the fourth conductive member 55B, the second resistance member 65B and the third conductive member 55A are circularly joined to form an electric circuit.

FIG. 2A

**(Cont. next page)**

# FIG. 2B

5A

51A

53A

55A

65A

65B

55B

53B

51B

57

α

β

**Description**

Technical Field

The present invention relates to a noise filter and an electric circuit in which the noise filter is provided.

Background Art

In an electric power source system, it is possible to decrease common mode noise, normal mode noise and reflection noise, and to reduce the influence of noise on a driven device (for example, Patent Literature 1).

Further, in Patent Literature 1, even in the case where a magnetic flux is generated in a core of a common mode choke by noise, and an induced electromotive force is then generated in an electric power source line by the magnetic flux, so that electric current flows to generate reflection noise in the electric power source line, the reflection noise can be reduced because a winding wire (W) and a seventh resistor (R7) connected to the winding wire (W) are included in the core of the common mode choke. In addition, even in the case where the noise reflected by the driven device passes through the common mode choke (13), a CR circuit (12) can consume the reflection noise through the conversion into thermal energy with the resistance component of a resistor (R2).

Meanwhile, for reducing the reflection noise for bidirectional electric current that flows through a pathway of the electric power source line (101, 102), a circuit that is symmetric with respect to a pathway direction is necessary, and at least six parts including CR circuits (12), common mode chokes (13, LR circuits) and CR circuits (15) are necessary.

Further, in recent years, with the improvement in the performance of semiconductors, the band of noise becomes higher frequencies, for example, about 30 MHz to 1 GHz, and for securing the characteristic of the noise filter for high frequencies, that is, for dealing with noises having short wavelengths, shortening of distances among parts, simplification of structures of parts, reduction in the number of parts, and the like are required.

The quarter-wavelength at which 1 GHz noise resonates is 75 mm in a vacuum, the product of the relative electric permittivity and relative magnetic permeability of the periphery of the noise is generally about 4, and the maximum length that allows the resonation to be prevented and at which the quarter-wavelength is about 38 mm is 3.8 mm when the maximum length is 1/10 of the quarter-wavelength.

For securing the characteristic of the noise filter for 1 GHz, there is a problem of a distance restriction in which distances among parts are set to 4 mm or less and repetition distances in winding repetition structures, lamination repetition structures and others of part structures are set to 4 mm or less. Further, for achieving both the increase in the size of the noise filter for high-current use and the distance restriction, there are problems of the reduction in the number of parts and the simplification of structures of parts themselves.

A composite electronic component in which a coil and a capacitor are unified using a material to serve as both a magnetic substance and a dielectric substance, that is, a composite material and that has functions of both of the coil and the capacitor as a single body can be applied to the noise filter (for example, Patent Literature 2, Patent Literature 3). Thereby, it is possible to meet the restriction of distances among parts, to realize the simplification of structures of part themselves and the reduction in the number of parts, and to solve the problem in Patent Literature 1.

Citation List

Patent Literature

    Patent Literature 1: JP 2000-244271 A
    Patent Literature 2: JP 56-6423 A
    Patent Literature 3: JP 2-268506 A

Summary of Invention

Technical Problem

However, in the case where a composite electronic member in Patent Literature 2 is applied to instead of the common mode choke (13) and the capacitor (C3) of the circuit in Patent Literature 1, the number of resistors in the winding wire (W) is one. Accordingly, the characteristic impedance of the noise filter portion is not a constant value, and varies depending on the frequency of the electric current that flows through the transmission line. Therefore, there is a problem in that the impedance matching with the transmission line cannot be performed.

Further, the composite material of the magnetic substance and the dielectric substance that is denoted by reference numeral 11 in FIG. 1 of Patent Literature 2 or is denoted by reference numeral 2 in FIG. 1 of Patent Literature 3 is necessary, the characteristics are inferior to those of a mere magnetic substance and dielectric substance, and there is a disadvantage in availability and price-vs-performance. There is a problem in the unification of the coil and the capacitor with no use of the composite material.

Hence, the present invention has an object to provide a noise filter and an electric circuit that are superior to Patent Literature 1 to Patent Literature 3.

Solution to Problem

A noise filter in the present invention includes: a first conductive member and a second conductive member that constitute a transmission line; a third conductive member that is disposed with a first intermediate member between the first conductive member and the third conductive member; a fourth conductive member that is disposed with a second intermediate member between the second conductive member and the fourth conductive member; a first resistance member and a second resistance member that electrically join the third conductive member and the fourth conductive member; and a first magnetic path that is formed in a region between the third conductive member and the fourth conductive member.

In the noise filter in the present invention, one or both of the first intermediate member and the second intermediate member is an insulator, and the third conductive member, the first resistance member, the fourth conductive member, the second resistance member and the third conductive member are circularly joined to form an electric circuit.

Preferably, the noise filter in the present invention includes a second magnetic path that is formed so as to surround outer circumferences of the first conductive member, the second conductive member, the third conductive member, the fourth conductive member, the first resistance member and the second resistance member, in which:

the first magnetic path and the second magnetic path magnetically communicate with each other; and
the first conductive member, the second conductive member, the third conductive member, the fourth conductive member, the first resistance member, the second resistance member and the first magnetic path are bundled and unified by the second magnetic path. This noise filter is referred to a second aspect.

Preferably, in the noise filter in the present invention, each of the first conductive member, the second conductive member, the third conductive member, the fourth conductive member, the first intermediate member and the second intermediate member has a strip shape.

Preferably, in the noise filter in the present invention, the first conductive member and the second conductive member are rod-shaped members, the third conductive member has a tubular shape that allows the first conductive member to be inserted into the third conductive member, and the fourth conductive member has a tubular shape that allows the second conductive member to be inserted into the fourth conductive member.

Preferably, in the noise filter in the present invention, the second conductive member has a rod shape, the fourth conductive member has a tubular shape that allows the second conductive member to be inserted into the fourth conductive member, the third conductive member has a tubular shape that allows the fourth conductive member to be inserted into the third conductive member, and the first conductive member has a tubular shape that allows the third conductive member to be inserted into the first conductive member.

The present invention provides an electric circuit including three noise filters, each of the three noise filters being the noise filter described above, the electric circuit having two three-phase alternating-current circuits through which electric currents flow, the electric currents being equivalent to each other, having opposite phases and being synchronized.

In this electric circuit, when respective phases of one three-phase alternating-current circuit of the two three-phase alternating-current circuits are U1, V1 and W1, respective phases of the other three-phase alternating-current circuit are U2, V2 and W2, a transmission line constituted by the phase U1 and the phase U2 is a transmission line T1, a transmission line constituted by the phase V1 and the phase V2 is a transmission line T2, a transmission line constituted by the phase W1 and the phase W2 is a transmission line T3, and the three noise filters are a noise filter A, a noise filter B and a noise filter C, the phase U1 of the transmission line T1 is connected to the first conductive member of the noise filter A, the phase V1 of the transmission line T2 is connected to the first conductive member of the noise filter B, the phase W1 of the transmission line T3 is connected to the first conductive member of the noise filter C, the phase U2 of the transmission line T1 is connected to the second conductive member of the noise filter A, the phase V2 of the transmission line T2 is connected to the second conductive member of the noise filter B, and the phase W2 of the transmission line T3 is connected to the second conductive member of the noise filter C.

The present invention provides an integrated-type noise filter including a plurality of noise filters, each of the plurality of noise filters being the noise filter according to the second aspect.

In this integrated-type noise filter, the first magnetic paths of the plurality of noise filters according to the second aspect are joined through a third magnetic path in a unified manner, the respective second magnetic paths of the plurality of noise filters according to the second aspect are spaced apart from each other, a relative magnetic permeability of the third magnetic path is higher than a relative magnetic permeability of the respective first magnetic paths of the plurality of noise filters, in a magnetic field of 500 Hz or lower, and the relative magnetic permeability of the third magnetic path is lower than the relative magnetic permeability of the respective first magnetic paths of the plurality of noise filters according to the second aspect, in a magnetic field of 1 MHz or higher.

The present invention provides another integrated-type noise filter including a plurality of noise filters according to the second aspect.

In this integrated-type noise filter, the respective first conductive members of the plurality of noise filters according to the second aspect are contained in a single fourth magnetic path, the respective second conductive members of the plurality of noise filters according to the second aspect are contained in a single fifth magnetic path, and the fourth magnetic path and the fifth magnetic path are disposed so as to be spaced apart, a relative magnetic permeability of the fourth magnetic path and the fifth magnetic path is higher than a relative magnetic permeability of the respective first magnetic paths of the plurality of noise filters according to the second aspect, in a magnetic field of 500 Hz or lower, and the relative magnetic permeability of the fourth magnetic path and the fifth magnetic path is lower than the relative magnetic permeability of the respective first magnetic paths of the plurality of noise filters according to the second aspect, in a magnetic field of 1 MHz or higher.

Advantageous Effects of Invention

According to the present invention, the third conductive member, the first resistance member, the fourth conductive member, the second resistance member and the third conductive member are circularly joined to form the electric circuit. Examples of the electric circuit with such a circular configuration include a circular electric circuit through the third conductive member, the first resistance member, the fourth conductive member, the second resistance member and the third conductive member. Hereinafter, this configuration is referred to as a circular conductive portion structure. By this circular conductive portion structure, the electric charge that the electric potential applied to one pathway of the transmission line, for example, to the first conductive member induces in the third conductive member facing the first conductive member through the first intermediate member and the electric charge that the electric potential applied to the other pathway of the transmission line, for example, to the second conductive member induces in the fourth conductive member facing the second conductive member through the second intermediate member can be exchanged. The exchange of the electric charges makes it possible to prevent high-frequency noises of each other from leaking outside, and in addition, makes it possible to increase the resistance component of the impedance of the noise filter and increase the loss when the electric current having a high frequency flows through the transmission line.

Brief Description of Drawings

FIG. 1 is a block diagram showing a schematic configuration of an electric motor drive device (electric power source system) according to a first embodiment of the present invention.
FIG. 2A and FIG. 2B each show a noise filter that is used in the electric motor drive device in FIG. 1, FIG. 2A being a perspective view, and FIG. 2B being a front view.
FIG. 3A, FIG. 3B and FIG. 3C each show an equivalent circuit of a circular conductive portion structure according to the first embodiment, FIG. 3A showing an example of one coil(L)-resistor ($R_L$) parallel circuit and one capacitor (C)-resistor ($R_C$) series circuit, FIG. 3B showing an example of one L-$R_L$ parallel circuit and two C-$R_C$ series circuits, FIG. 3C showing an example of two L-$R_L$ parallel circuits and one C-$R_C$ series circuit.
FIG. 4 is a diagram schematically showing a secondary circuit of the noise filter according to the first embodiment.
FIG. 5 is an equivalent circuit diagram of the noise filter according to the first embodiment.
FIG. 6 is a diagram showing the electric state of the noise filter according to the first embodiment.
FIG. 7A. FIG. 7B and FIG. 7C each are a front view showing a first modification of the noise filter according to the first embodiment.
FIG. 8A and FIG. 8B each are a front view showing a second modification of the noise filter according to the first embodiment.
FIG. 9A, FIG. 9B and FIG. 9C each show the configuration of a noise filter according to a second embodiment, FIG. 9A being a front view, FIG. 9B being a cross-sectional view, FIG. 9C being a side view.
FIG. 10A and FIG. 10B each are a front view showing the configuration of a noise filter according to a third embodiment.
FIG. 11A and FIG. 11B each are a front view showing the configuration of a noise filter according to a fourth embodiment.

FIG. 12 is a front view showing the configuration of a noise filter according to a fifth embodiment.

FIG. 13 is a front view showing the configuration of a noise filter according to a sixth embodiment.

FIG. 14 is a diagram showing the configuration of an electric circuit in the case where the noise filter according to the embodiment is applied and is used as a terminating resistor.

FIG. 15 is a diagram comparing and showing FIG. 2B, FIG. 4 and FIG. 7A that correspond to the first embodiment, for supplemental explanation of the third embodiment.

FIG. 16 is a diagram comparing and showing FIG. 2B corresponding to the first embodiment and FIG. 10A corresponding to the third embodiment, for supplemental explanation of the third embodiment.

FIG. 17 is a diagram comparing and showing FIG. 2B corresponding to the first embodiment and FIG. 11A corresponding to the fourth embodiment, for supplemental explanation of the fourth embodiment.

Description of Embodiments

A noise filter according to an embodiment of the present invention and an electric motor drive device as an electric circuit to which the noise filter is applied will be described below with reference to the accompanying drawings.

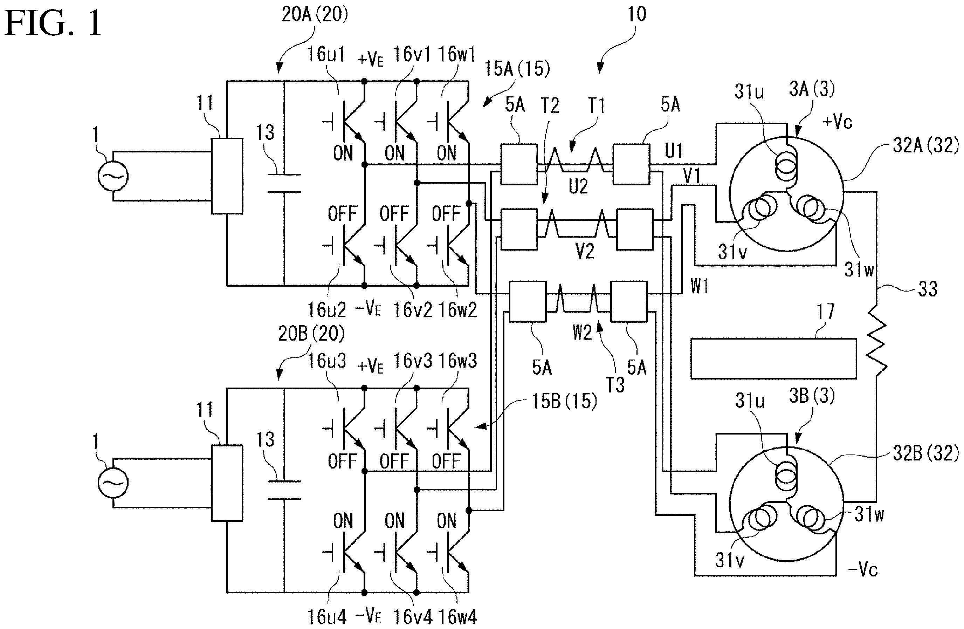

As shown in FIG. 1, an electric motor drive device 10 according to the embodiment converts alternating current output from a three-phase alternating-current power source 1, into direct current, converts the direct current after the conversion into alternating current, supplies the alternating current to a three-phase alternating-current electric motor, and drives the three-phase alternating-current electric motor. In the embodiment, a servomotor 3 is shown as an example of the three-phase alternating-current electric motor, but the three-phase alternating-current electric motor in the present invention is not limited to the servomotor, and includes an electric motor (actuator) or electric generator with three-phase alternating current that is driven by an inverter circuit, as exemplified by an induction electric motor, a synchronous electric motor and a Permanent Magnet (PM) motor.

In the electric motor drive device 10, noise filters 5A are provided on a transmission line T1 (pathway (phase) U1, U2), a transmission line T2 (pathway (phase) V1, V2) and a transmission line T3 (pathway (phase) W1, W2) between a first servomotor 3A and second servomotor 3B and a first inverter circuit 20A and second inverter circuit 20B.

[Overall Configuration of Electric Motor Drive Device: FIG. 1]

As shown in FIG. 1, the electric motor drive device 10 in the embodiment includes the first servomotor 3A and the second servomotor 3B, and the first inverter circuit 20A and the second inverter circuit 20B are provided so as to correspond to the first servomotor 3A and the second servomotor 3B respectively. Hereinafter, the first servomotor 3A and the second servomotor 3B are referred to as merely a servomotor 3 when it is not necessary to distinguish the two, and the first servomotor 3A and the second servomotor 3B are referred to as the first servomotor 3A and the second servomotor 3B when it is necessary to distinguish the two. The same applies to an inverter circuit 20 and constituent elements thereof.

One of the combination of the first servomotor 3A and the first inverter circuit 20A and the combination of the second servomotor 3B and the second inverter circuit 20B has an opposite-phase current generation function for the other.

As shown in FIG. 1, the inverter circuit 20 includes a rectifier 11 that converts the alternating current output from the three-phase alternating-current power source 1, into direct current, a smoothing capacitor 13 that is provided between the rectifier 11 and an inverter main circuit 15, and the inverter main circuit 15 that receives the direct current from the rectifier 11 and that drives the servomotor 3, as major constituent elements.

Further, the inverter circuit 20 includes an inverter control unit 17 that controls the inverter main circuit 15. The inverter control unit 17 controls the turning-on and turning-off of semiconductor switching elements 16u1, 16u2, 16u3, 16u4, 16v1, 16v2, 16v3, 16v4, 16w1, 16w2, 16w3, 16w4 that constitute the inverter main circuit 15. The semiconductor switching elements are collectively referred to as a semiconductor switching element 16 when individual denotation is not necessary. As shown in FIG. 1, both of the inverter main circuits 15A, 15B are controlled by the single inverter control unit 17, but an inverter control unit corresponding to the inverter main circuit 15A and an inverter control unit corresponding to the inverter main circuit 15B may be separately provided.

The inverter control unit 17 controls the turning-on and turning-off of the semiconductor switching elements 16 that constitute the inverter main circuit 15A and the inverter main circuit 15B respectively, such that alternating currents having mutually opposite phases are supplied to the first servomotor 3A and the second servomotor 3B. The inverter control unit 17 controls the turning-on and turning-off of the semiconductor switching elements 16, by detecting the electric current of the servomotor 3 and detecting the voltage of the smoothing capacitor 13. Further, the inverter control unit 17 performs a mutually synchronous control of the operations of the first servomotor 3A and the second servomotor 3B, based on information from the respective encoders of the servomotors 3A, 3B.

[Servomotor 3: FIG. 1]

As shown in FIG. 1, the servomotor 3 is a three-phase alternating-current servomotor, and includes three coils 31u, 31v, 31w each of which is constituted by a winding wire, and a stator 32 (32A, 32B) constituted by an electric conductor around which the coils 31u, 31v, 31w are wound. In addition to the coils 31u, 31v, 31w and the stator (stator member) 32, the servomotor 3 includes a rotor (rotor member) that is provided on the inside of the stator 32 in a rotatable manner, but the illustration is omitted in FIG. 1. The rotor may be constituted by a permanent magnet, or may be constituted by a coil or a cage.

The first servomotor 3A and the second servomotor 3B have the same specification, and a mutually synchronous control of the operations is performed. The first servomotor 3A corresponds to one of a first motor group and a second motor group, and the second servomotor 3B corresponds to the other of the first motor group and the second motor group. In the embodiment, the number N of servomotors 3 in each of the first motor group and the second motor group is 1, and is the same value. The stator 32A and stator 32B of the first servomotor 3A and second servomotor 3B are electrically connected by a conductor 33. The conductor 33 can be connected to an earth E.

[Rectifier 11: FIG. 1]

The rectifier 11 is constituted by an element that has a rectifying function to cause electric current to flow only in one direction, and converts the alternating current output from the three-phase alternating-current power source 1, into direct current. For example, the rectifier 11 includes a pair of rectifying diodes, and rectifies alternating current that alternately flows through them. In order that the alternating current alternately flows through the pair of rectifying diodes, for example, the rectifier 11 includes semiconductor switching elements that corresponds to the pair of rectifying diodes respectively. The rectifier 11 can be replaced with a converter that can supply electric current from the electric motor side to the rectifier 11 side by regeneration or electric generation.

[Smoothing Capacitor 13: FIG. 1]

The smoothing capacitor 13 smooths signals such that ripples generated after the rectification by the rectifier 11 are restrained and electric current closer to direct current is obtained. By inserting the smoothing capacitor 13 after the rectification, electricity is stored when the voltage is high, and electricity is discharged when the voltage is low, so that the variation in voltage is effectively restrained.

[Inverter Main Circuit 15 (15A, 15B): FIG. 1]

As shown in FIG. 1, the inverter main circuit 15 is configured to include the semiconductor switching elements 16 that respectively correspond to the coils 31u, 31v, 31w in a u-phase, v-phase and w-phase that are included in the servomotor 3. The semiconductor switching elements 16 are provided as respective pairs. That is, in the inverter main circuit 15A, the semiconductor switching elements 16u1, 16v1, 16w1 disposed on an upper side in the figure and the semiconductor switching elements 16u2, 16v2, 16w2 disposed on a lower side in the figure are separately provided. Further, in the inverter main circuit 15B, the semiconductor switching elements 16u3, 16v3, 16w3 disposed on an upper side in the figure and the semiconductor switching elements 16u4, 16v4, 16w4 disposed on a lower side in the figure are separately provided.

The inverter main circuit 15 supplies drive currents generated by the switching of the semiconductor switching element 16, that is, by the turning-on and the turning-off, to the coils 31u, 31v, 31w of the servomotor 3, as an inverter circuit output.

The semiconductor switching element 16 can be constituted by a semiconductor element such as an insulated gate bipolar transistor (IGBT) and a metal-oxide-semiconductor field-effect transistor (MOSFET).

[Inverter Control Unit 17: FIG. 1]

The inverter control unit 17 controls the turning-on and turning-off of each of the semiconductor switching elements 16 that constitute the inverter main circuits 15A, 15B. Through this control, the inverter main circuits 15A, 15B performs the synchronous control of the servomotors 3A, 3B. The inverter control unit 17 controls the turning-on and turning-off of each of the semiconductor switching elements 16, such that electric currents having mutually opposite phases are supplied to the first servomotor 3A and the second servomotor 3B. This is realized by delaying the switching cycle of one of the inverter main circuits 15A, 15B by the inverter control unit 17, relative to the cycle of the switching operation of the other of the inverter main circuits 15A, 15B, by a phase length of half cycle.

[Connection Form between Servomotor 3 and Inverter Circuit 20: FIG. 1]

The first servomotor 3A, the second servomotor 3B, the first inverter circuit 20A and the second inverter circuit 20B are connected by the transmission line T1 constituted by the pathway U1 and the pathway U2, the transmission line T2 constituted by the pathway V1 and the pathway V2, and the transmission line T3 constituted by the pathway W1 and the pathway W2. Details are shown as follows.

Th coil 31u of the first servomotor 3A and the semiconductor switching elements 16u1, 16u2 in the first inverter circuit 20A are connected by the pathway U1.

The coil 31u of the second servomotor 3B and the semiconductor switching elements 16u3, 16u4 in the second inverter circuit 20B are connected by the pathway U2.

The coil 31v of the first servomotor 3A and the semiconductor switching elements 16v1, 16v2 in the first inverter circuit 20A are connected by the pathway V1.

The coil 31v of the second servomotor 3B and the semiconductor switching elements 16v3, 16v4 in the second inverter circuit 20B are connected by the pathway V2.

The coil 31w of the first servomotor 3A and the semiconductor switching elements 16w1, 16w2 in the first inverter circuit 20A are connected by the pathway W1.

The coil 31w of the second servomotor 3B and the semiconductor switching element 16w3, 16w4 in the second inverter circuit 20B are connected by the pathway W2.

Each of the transmission line T1 (the pathways U1, U2), the transmission line T2 (the pathways V1, V2) and the transmission line T3 (the pathways W1, W2) is provided with two noise filters 5A, but may be provided with one noise filter 5A. Alternatively, the noise filter 5A may be provided only any one of the transmission lines.

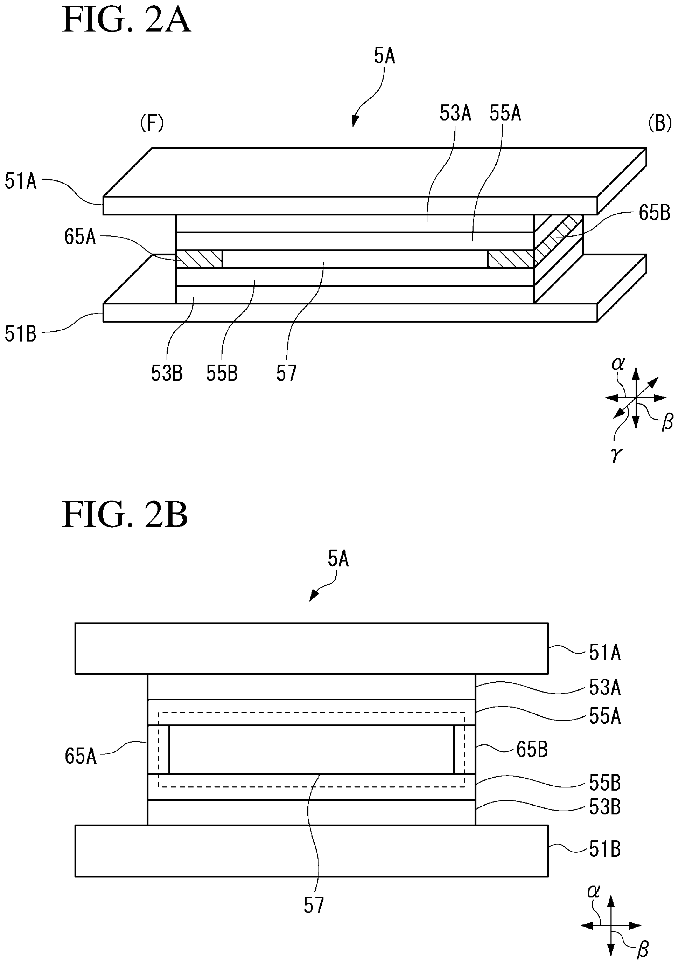

[Configuration of Noise Filter 5A: FIG. 2A and FIG. 2B]

As an example, the structure of the noise filter 5A that has a strip shape and that extends along a length direction $\alpha$ will be described with reference to FIG. 2A and FIG. 2B. For explanatory convenience, the length direction $\alpha$, a width direction $\gamma$ and a thickness direction $\beta$ are specified as shown in FIG. 2A and FIG. 2B. Further, for the noise filter 5A, a front end (F) and a back end (B) are specified as shown in FIG. 2A and FIG. 2B.

The noise filter 5A includes a first conductive member 51A and a second conductive member 51B that are provided with a predetermined gap on both outsides in the thickness direction $\beta$, and a first intermediate member 53A and a second intermediate member 53B that are provided so as to contact with the respective insides of the first conductive member 51A and the second conductive member 51B. Further, the noise filter 5A includes a third conductive member 55A and a fourth conductive member 55B that are provided so as to contact with the insides of the first intermediate member 53A and the second intermediate member 53B, and a first magnetic path 57 that is sandwiched between the third conductive member 55A and the fourth conductive member 55B. Furthermore, the noise filter 5A includes a first resistance member 65A and a second resistance member 65B that are respectively provided on both sides of the first magnetic path 57 in the length direction $\alpha$, between the third conductive member 55A and the fourth conductive member 55B. The first resistance member 65A is provided on the front end (F) side, and the second resistance member 65B is provided on the back end (B) side.

In the above noise filter 5A, as an example, the first conductive member 51A is connected to the pathways U1, V1, W1 of the transmission lines T1, T2, T3, and the second conductive member 51B is connected to the pathways U2, V2, W2 of the transmission lines T1, T2, T3, so that portions of the transmission lines are configured.

The first conductive member 51A to the fourth conductive member 55B are composed of a metal material having a low electric resistivity, as exemplified by copper and a copper alloy. Among them, the first conductive member 51A and the second conductive member 51B are formed so as to have the same dimensions in the length direction $\alpha$, the thickness direction $\beta$ and the width direction $\gamma$. Further, among them, the third conductive member 55A and the fourth conductive member 55B are formed so as to have the same dimensions in the length direction $\alpha$, the thickness direction $\beta$ and the width direction $\gamma$. However, the third conductive member 55A and the fourth conductive member 55B are formed so as to be smaller than the first conductive member 51A and the second conductive member 51B in the dimensions in the length direction $\alpha$ and the thickness direction $\beta$.

The first intermediate member 53A and the second intermediate member 53B are composed of an electric insulating material exemplified below.

As an example, the first intermediate member 53A and the second intermediate member 53B are formed so as to have the same dimensions in the length direction $\alpha$, the thickness direction $\beta$ and the width direction $\gamma$. Further, as an example, the first intermediate member 53A and the second intermediate member 53B are formed so as to be the same as the third conductive member 55A and the fourth conductive member 55B in the dimensions in the length direction $\alpha$ and the width direction $\gamma$.

Examples of Electric Insulating Material Composing First Intermediate Member 53A and Second Intermediate Member 53B

Resin Material: polyethylene, polyethylene foam, poly-perfluoro alkoxy ethylene (PFA), polytetrafluoroethylene, polyethylene terephthalate, polypropylene, polyphenyl sulfide, polyethylene naphthalate, polystyrene, polycarbonate, polyester
Compound: barium titanate ($BaTiO_3$), aluminum oxide ($Al_2O_3$), titanium oxide ($TiO_3$), calcium zirconate ($CaZr_3$), silicon oxide ($SiO_2$)
Gas: air, nitrogen gas, sulfur hexafluoride
Others: glass

The first magnetic path 57 is composed of a ferromagnetic material (soft magnetic material) exemplified below. Note that the same material can also be applied to a later-described second magnetic path 58, third magnetic path 59, fourth magnetic path 61 and fifth magnetic path 63.

Further, the first resistance member 65A and the second resistance member 65B are composed of a material (high-resistance material) having a high electric resistivity as exemplified below. As an example, the first resistance member 65A and the second resistance member 65B have the same dimension in the thickness direction $\beta$ as the first magnetic path 57.

As an example, the total of the dimensions of the three members of the first magnetic path 57, the first resistance member 65A and the second resistance member 65B in the length direction $\alpha$ is the same as the dimension of the first intermediate member 53A or the like in the length direction $\alpha$.

Examples of Ferromagnetic Material Composing First Magnetic Path 57:

Soft Ferrite Material: Ni-Zn ferrite, Mn-Zn ferrite
Metal-Based Material: permalloy, amorphous alloy (Co group, Fe group), nanocrystal soft magnetic alloy (Co group, Ni group, Fe group)

Examples of High-Resistance Material Composing First Resistance Member 65A and Second Resistance Member 65B:
Metal film, metal oxide film, metal glaze, carbon film, nichrome alloy

In the noise filter 5A having the above laminate structure, the third conductive member 55A, the fourth conductive member 55B, the first resistance member 65A and the second resistance member 65B constitute a circular electric path through the third conductive member 55A, the first resistance member 65A, the fourth conductive member 55B, the second resistance member 65B, the third conductive member 55A, etc. The circular electric path, that is, a circular conductive portion structure is shown by a broken line arrow in FIG. 2B. In the circular conductive portion structure, electric current may flow in the order of the third conductive member 55A, the first resistance member 65A, the fourth conductive member 55B, the second resistance member 65B, the third conductive member 55A, etc. as described above, or may flow in the opposite order.

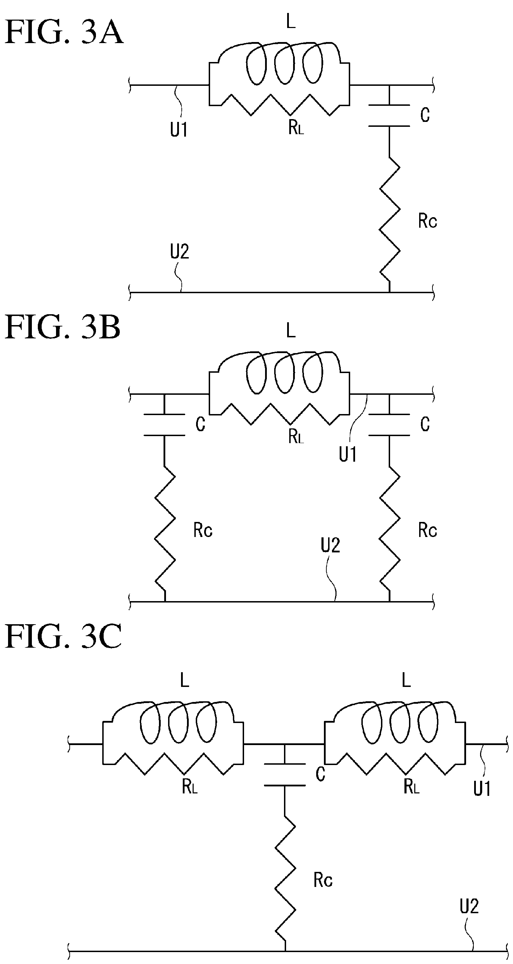

[Effect of Noise Filter 5A: FIGS. 3A, 3B and 3C]

As shown in FIG. 3A, FIG. 3B and FIG. 3C, the above circular conductive portion structure is equivalent to the formation of a coil(L)-resistor ($R_L$) parallel circuit in series with the transmission line T1 (the pathways U1, U2) and the formation of a capacitor (C)-resistor ($R_C$) series circuit in parallel with the transmission line T1 (the pathways U1, U2). Note that FIG. 3A, FIG. 3B and FIG. 3C exemplify the transmission line T1 (the pathways U1, U2), but the same applies to the transmission line T2 (the pathways V1, V2) and the transmission line T3 (the pathways W1, W2). The coil(L)-resistor ($R_L$) parallel circuit and the capacitor (C)-resistor ($R_C$) series circuit are arranged in patterns shown in FIG. 3A, FIG. 3B and FIG. 3C.

[Effect about Impedance]

On the premise of FIG. 3A, FIG. 3B and FIG. 3C, the first resistance member 65A is provided on one end side that is connected to the transmission line between the first conductive member 51A and the second conductive member 51B, and the second resistance member 65B is provided on the other end side that is connected to the transmission line between the first conductive member 51A and the second conductive member 51B. Thereby, as shown in FIG. 2B, the third conductive member 55A, the fourth conductive member 55B, the first resistance member 65A and the second resistance member 65B are circularly joined. That is, the first resistance member 65A and the second resistance member 65B are disposed in parallel with each other, and both of the first resistance member 65A and the second resistance member 65B disposed in parallel are disposed in series with the third conductive member 55A and the fourth conductive member 55B. By this circular conductive portion structure, electric charge A that the electric potential applied to one pathway of the transmission line, for example, to the first conductive member 51A induces in the third conductive member 55A facing the first conductive member 51A through the first intermediate member 53A and electric charge B that the electric potential applied to the other pathway of the transmission line, for example, to the second conductive member 51B induces in the fourth conductive member 55B facing the second conductive member 51B through the second intermediate member 53B can be exchanged.

As described later in detail, in the embodiment, it is possible to simplify member shapes, to secure the symmetry of material disposition, and to increase the dimension accuracy of members. Thereby, it is possible to equalize the capacitance, frequency characteristic, temperature characteristic and others of a capacitor structure constituted by the first conductive member 51A, the first intermediate member 53A and the third conductive member 55A, with the capacitance, frequency characteristic, temperature characteristic and others of a capacitor structure constituted by the second conductive member 51B, the second intermediate member 53B and the fourth conductive member 55B. As a result, it is possible to reduce the electric charge difference between the electric charge A and electric charge B due to the symmetric noise included in the electric current applied to the first conductive member and the second conductive member. The exchange of the equal electric charges makes it possible to prevent high-frequency noises of each other from leaking outside, and in addition, makes it possible to increase the resistance component of the impedance of the noise filter 5A and increase the loss when the electric current having a high frequency flows through the transmission line.

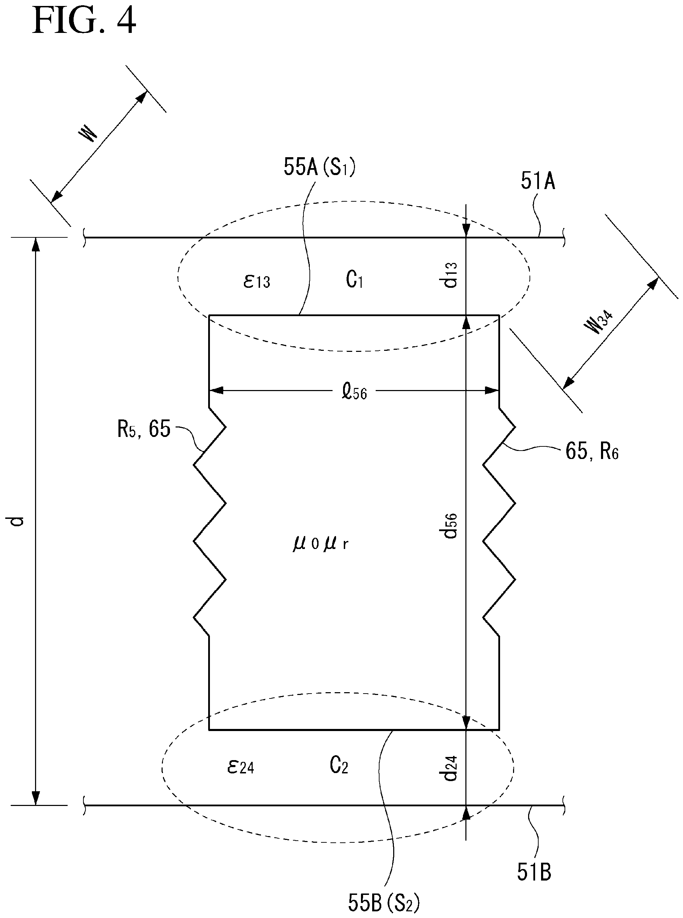

As is clear from FIG. 4 schematically showing a secondary circuit of the noise filter 5A, a capacitor structure "C" and each resistance member "R" have a series connection, that is, a configuration of a CR circuit. As shown in FIG. 4, the CR circuit is between the first conductive member 51A and second conductive member 51B that constitute the transmission line. In the case where low-frequency electric current flows through the transmission line, the electric current that flows through the R is small because the impedance of the C of the CR circuit is high, and in the case where high-frequency electric current flows through the transmission line, the electric current that flows through the R is large because the impedance of the C of the CR circuit is low.

Consequently, in the case where high-frequency electric current flows through the transmission line, the electric current that flows through the R is large, and the loss is large, so that the resistance member R functions as a filter that removes high-frequency waves.

The resistance member can be joined in series for the induced current that the electric current flowing through the transmission line (the first conductive member 51A and the second conductive member 51B) generates in the third conductive member 55A and the fourth conductive member 55B that face the first conductive member 51A and the second conductive member 51B through the first intermediate member 53A and the second intermediate member 53B (intermediate member). Thereby, when the electric current having a low frequency flows through the transmission line, it is possible to reduce the resistance component of the impedance of the noise filter 5A, and to reduce the loss.

The above detailed content is shown as follows.

It is possible to perform current superposition of the electrogenic current due to a first electromagnetic induction from the electric current applied to one pathway of the transmission line, for example, to the first conductive member 51A to the above circular conductive portion structure and the electrogenic current due to a second electromagnetic induction from the electric current applied to the other pathway of the transmission line, for example, to the second conductive member 51B to the circular conductive portion structure. The current superposition has a load by flowing in series through the first resistance member 65A and second resistance member 65B of the circular conductive portion structure, and this load is referred to as a secondary load.

The secondary load can be converted into a load for the electric current applied to the first conductive member 51A. This conversion load is referred to as a first primary conversion load, and the rate in the conversion is referred to as a first conversion rate. Further, the secondary load can be converted into a load for the electric current applied to the second conductive member 51B. This conversion load is referred to as a second primary conversion load, and the rate in the conversion is referred to a second conversion rate.

That is, a transformer structure in which the primary side is each transmission line side and the secondary side is the circular conductive portion structure is shown as follows.

(1) In the case where low-frequency current flows through the primary side, the induced voltage to the secondary side is small.

(2) In the case where high-frequency current flows through the primary side, the induced voltage to the secondary side is large.

Consequently, in the case where high-frequency current flows through the transmission line on the primary side, the induced voltage to the circular conductive portion structure on the secondary side is large, the electric current that flows through each resistance member is large, and the loss is large, so that the above transformer structure functions as a filter that removes high-frequency waves.

When the first conductive member 51A, the second conductive member 51B, the third conductive member 55A, the fourth conductive member 55B, the first intermediate member 53A, the second intermediate member 53B, the first resistance member 65A and the second resistance member 65B are referred to as respective members, the respective members have shapes that are easily formed, as exemplified by a strip shape, a rod shape or a tubular shape, and a dimension error of less than $\pm 1\%$ can be secured using a general processing technology.

When the dimension error is small, it is possible to reduce the difference in position relation between the position relation of the first conductive member 51A and the above-described circular conductive portion structure and the position relation of the second conductive member 51B and the circular conductive portion structure.

Further, the first conductive member 51A and the second conductive member 51B are composed of an identical material, the third conductive member 55A and the fourth conductive member 55B are composed of an identical material, the first intermediate member 53A and the second intermediate member 53B are composed of an identical material, and the first resistance member 65A and the second resistance member 65B are composed of an identical material. Thereby, it is possible to eliminate the difference in material disposition relation between the disposition relation of the materials of respective members including the first conductive member 51A and the circular conductive portion structure and the disposition relation of the materials of respective members including the second conductive member 51B and the circular conductive portion structure.

By reducing the difference in position relation and eliminating the difference in material disposition relation, it is possible to reduce the differences in frequency characteristic and temperature characteristic, in the difference between the above first electromagnetic induction and the above second electromagnetic induction.

Since the difference in position relation is reduced and the difference in material disposition relation is eliminated between the first conductive member 51A or second conductive member 51B and the circular conductive portion structure, it is possible to equalize the first conversion rate with the second conversion rate.

Since the first primary conversion load and the second primary conversion load have a common secondary load which is composed of the circular conductive portion structure and it is possible to equalize the first conversion rate with the second conversion rate, it is possible to equalize the first primary conversion load with the second primary conversion load.

When the first conductive member 51A and the second conductive member 51B can have an equal primary conversion load, it is possible to symmetrically lose and surely cancel the symmetric noise current that is included in the electric current applied to the first conductive member 51A and the second conductive member 51B. This is a noise filter having a positive-negative symmetric structure.

In Patent Literature 1, a coil having a winding structure is used as a common mode coil (13), and generally, the tolerance of the coil having a winding structure is $\pm 5\%$ to $\pm 10\%$. Even when the positive-negative symmetric noise is applied to the common mode coil (13), the difference in loss between a positive noise that flows on a first pathway side and a negative noise that flows on a second pathway side becomes up to $\pm 10\%$ to $\pm 20\%$ of twice the tolerance, and the noises cannot be canceled.

Even when the noise filter in Patent Literature 1 does not have the positive-negative symmetric structure, there is no problem depending on noise intensity and frequency distribution. The noise filter in the embodiment can also have a structure that is not the positive-negative symmetric structure, and there is no problem depending on noise intensity and frequency distribution.

Furthermore, as described later, the impedance of the noise filter 5A can be determined from the ratio between an inductance L constituted by the first conductive member 51A and the second conductive member 51B and a capacitor C constituted by the first conductive member 51A, the second conductive member 51B, the third conductive member 55A and the fourth conductive member 55B, and the ratio between the first resistance member 65A and the second resistance member 65B. Accordingly, the impedance can be caused to be constant regardless of the magnitude of the loss, and therefore, impedance matching is easy.

A distinctive characteristic impedance matching in the embodiment will be described below. Hereinafter, the electric permittivity of vacuum is $\varepsilon_0$, and the magnetic permeability of vacuum is $\mu_0$.

(1) Characteristic Impedance of Transmission Line

In the case where the transmission line is a parallel plate, when the width of the first conductive member 51A and the second conductive member 51B is W and the distance between the first conductive member 51A and the second conductive member 51B is d as shown in FIG. 4, the characteristic impedance $Z_{dpp}$ is shown as Expression (1). W, d and others are shown in FIG. 4.

[Expression (1)]

$$Z_{dpp} = \sqrt{\frac{\mu_0}{\varepsilon_0} \frac{d}{W}} \, [\Omega]$$

(2) Characteristic Impedance of Secondary Circuit

Next, the characteristic impedance of the secondary circuit of the noise filter 5A will be described with reference to FIG. 4. Note that the specifications of the respective members are defined as follows. An electrostatic capacitance 1 ($C_1$) between the first conductive member 51A and the third conductive member 55A and an electrostatic capacitance 2 ($C_2$) between the second conductive member 51B and the fourth conductive member 55B in FIG. 4 will be shown as Expression (2). Further, a series connection capacitance $C_{34}$ of the electrostatic capacitance 1 ($C_1$) and the electrostatic capacitance 2 ($C_2$) is shown as Expression (3), and an inductance $L_{56}$ of the circular conductive portion structure is shown as Expression (4).

[Expression (2)]

$$C_1 = \varepsilon_0 \varepsilon_{13} \frac{S_1}{d_{13}} [F] \quad , \quad C_2 = \varepsilon_0 \varepsilon_{24} \frac{S_2}{d_{24}} [F]$$

[Expression (3)]

$$C_{34} = \frac{C_1 C_2}{C_1 + C_2} [F]$$

[Expression (4)]

$$L_{56} = \mu_0 \mu_r \frac{d_{56} l_{56}}{W_{34}} [H]$$

[Specification of Member]

The relative electric permittivity of the first conductive member 51A and the third conductive member 55A: $\varepsilon 13$
The relative electric permittivity of the second conductive member 51B and the fourth conductive member 55B: $\varepsilon 24$
The distance between the first conductive member 51A and the third conductive member 55A: d13
The distance between the second conductive member 51B and the fourth conductive member 55B: d24
The surface area of the third conductive member 55A: S1, the surface area of the fourth conductive member 55B: S2
The length of the third conductive member 55A and the fourth conductive member 55B: $l_{56}$
The relative magnetic permeability of the magnetic path 17: $\mu_r$

A distance $W_{34}$ resulting from subtracting the thickness of dielectric + third conductive member 55A + fourth conductive member 55B + dielectric from $d_{56}$ in Expression (4) coincides with the width of the third conductive member 55A and the fourth conductive member 55B.

When the resistance value of the first resistance member 65A is $R_5$ Ω and the resistance value of the second resistance member 65B is $R_6$ Ω, Expression (5) is obtained, because the first resistance member 65A and second resistance member 65B relevant to the series connection capacitance $C_{34}$ are connected in parallel.

[Expression (5)]

$$\frac{R_5 R_6}{R_5 + R_6} [\Omega]$$

The resistance value of the circular conductive portion structure is shown as Expression (6), because the first resistance member 65A and the second resistance member 65B are connected in series.

[Expression (6)]

$$R_5 + R_6 [\Omega] \quad , \qquad \text{Conductance} = \frac{1}{R_5 + R_6} [S]$$

Next, when the angular velocity of the alternating current that is transmitted between the first conductive member 51A and the second conductive member 51B is ω rad/s, a characteristic impedance $Z_0$ of the noise filter 5A is shown as Expression (7).

On the premise of Expression (8), in which k is an arbitrary value, Expression (7) becomes Expression (9), and ω is eliminated. Thereby, theoretically, the characteristic impedance of the noise filter 5A can caused to be constant without depending on frequency.

[Expression (7)]

$$Z_o = \sqrt{\frac{\dfrac{R_5 R_6}{R_5 + R_6} + \dfrac{1}{j\omega C_{34}}}{\dfrac{1}{R_5 + R_6} + \dfrac{1}{j\omega L_{56}}}} [\Omega]$$

[Expression (8)]

$$k = \frac{\dfrac{R_5 R_6}{R_5 + R_6}}{\dfrac{1}{R_5 + R_6}} = \frac{\dfrac{1}{j\omega C_{34}}}{\dfrac{1}{j\omega L_{56}}} \quad , \quad k = R_5 R_6 = \frac{L_{56}}{C_{34}}$$

[Expression (9)]

$$Z_o = \sqrt{\frac{\dfrac{k}{R_5 + R_6} + \dfrac{k}{j\omega L_{56}}}{\dfrac{1}{R_5 + R_6} + \dfrac{1}{j\omega L_{56}}}} = \sqrt{k}\,[\Omega]$$

Next, when k that satisfies Expression (10) is selected from the characteristic impedance of the transmission line in Expression (1), the impedance matching with the transmission line can be performed.

From Expression (11), a frequency at which the impedance ratio between loss and non-loss is 1:1 is obtained by Expression (12).

When $\omega$ is sufficiently larger than $\omega_0$ in Expression (7), that is, when the frequency is high, Expression (13) is satisfied and Expression (14) is satisfied, so that the resistance component becomes valid.

Further, when $\omega$ is sufficiently smaller than $\omega_0$ in Expression (7), that is, when the frequency is low, Expression (15) is satisfied and Expression (16) is satisfied, so that the resistance component becomes invalid.

[Expression (10)]

$$Z_{dpp} = \sqrt{k}\,[\Omega]$$

[Expression (11)]

$$\omega_0 = \frac{R_5 + R_6}{j L_{56}} = \frac{R_5 + R_6}{j C_{34} R_5 R_6}\,[rad/s]$$

[Expression (12)]

$$\frac{1}{2\pi\omega_0}[Hz]$$

[Expression (13)]

$$\frac{R_5 R_6}{R_5 + R_6} \gg \frac{1}{j\omega C_{34}} \ , \frac{1}{R_5 + R_6} \gg \frac{1}{j\omega L_{56}}$$

[Expression (14)]

$$Z_o = \sqrt{R_5 R_6}\,[\Omega]$$

[Expression (15)]

$$\frac{R_5 R_6}{R_5 + R_6} \ll \frac{1}{j\omega C_{34}} \ , \frac{1}{R_5 + R_6} \ll \frac{1}{j\omega L_{56}}$$

[Expression (16)]

$$Z_o = \sqrt{\frac{L_{56}}{C_{34}}}\,[\Omega]$$

[Strip Shape Structure: FIG. 2B]

In the noise filter 5A, when the first conductive member 51A and the second conductive member 51B are transmission lines having a parallel and flat shape, it is possible to uniform the mutually facing shapes of the first conductive member 51A and the second conductive member 51B. Thereby, in the coil structure in which a magnetic field generated between each other is used, it is possible to uniform the distributions of magnetic fields respectively generated from the first conductive member 51A and the second conductive member 51B, and in the capacitor structure in which an electric field generated between the first conductive member 51A and the second conductive member 51B is used, it is possible to uniform the density of the induced electric charge. This configures a symmetric electric field and magnetic field with no bias, and facilitates the prevention of noise diffusion.

[Simplification of Capacitor Structure and Transformer Structure]

Further, according to the noise filter 5A, it is possible to simplify the capacitor structure itself by directly using the electric field generated between the first conductive member 51A and the second conductive member 51B that constitute the transmission line, and realizing the capacitor structure with a single electrode plate by configuring the capacitor structure with the transmission line and the third conductive member 55A or the fourth conductive member 55B, although the capacitor structure generally requires two electrode plates.

Moreover, it is possible to simplify the transformer structure itself by configuring the transformer structure between the transmission line and the circular conductive portion structure by directly using the magnetic field generated between the first conductive member 51A and the second conductive member 51B that constitute the transmission line, and realizing the transformer structure with a single coil although the transformer structure generally requires two coils.

[Noise Filter 5A Having Symmetric Structure]

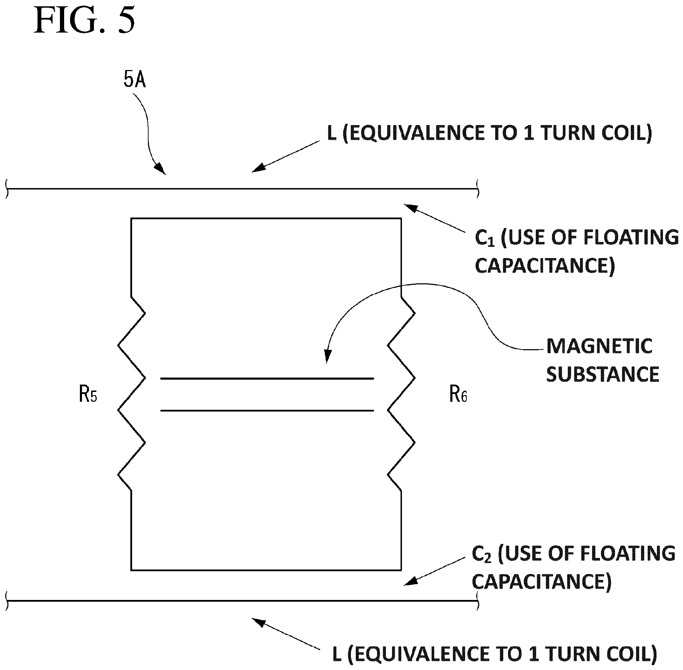

It is possible to configure the noise filter 5A having the symmetric structure for the bidirectional electric current that flows through the transmission line, with a total of four parts including the first resistance member 65A and the second resistance member 65B that connect the third conductive member 55A and the fourth conductive member 55B. FIG. 5 shows an equivalent circuit diagram of the noise filter 5A having the symmetric structure.

Furthermore, in the noise filter 5A, it is only necessary to perform at least one insulation of the insulation between the first conductive member 51A and the third conductive member 55A and the insulation between the second conductive member 51B and the fourth conductive member 55B. Accordingly, it is possible to configure the noise filter 5A having the symmetric structure for the bidirectional electric current that flows through the transmission line, with a total of three parts, by selecting either a unification by which the third conductive member 55A is included in the first conductive member 51A or a unification by which the fourth conductive member 55B is included in the second conductive member 51B.

[Distance between Coil and Capacitor Is 0]

Furthermore, the noise filter 5A allows the distance between the coil and the capacitor to be 0, by using the third conductive member 55A or the fourth conductive member 55B as both of an electric wire of the coil and an electrode of the capacitor. Thereby, it is possible to exclude a winding repetition structure from the coil, and to exclude a lead structure (a leg of a part) and a lamination repetition structure from the capacitor. As a result, it is possible to eliminate floating capacitance and parasitic inductance, and to raise the upper limit of the frequency depending on structures. Furthermore, it is possible to raise the upper limits of the frequency allowing the ratio between the inductance of the coil and the capacitance of the capacitor to be constant and the frequency allowing the impedance determined from the ratio between the inductance of the coil and the capacitance of the capacitor to be constant, and therefore, it is possible to perform the impedance matching with the transmission line, even in a high frequency range.

[Choice of Materials]

Further, in the noise filter 5A, different materials can be applied to the first magnetic path 57 that bears the magnetic field and the first intermediate member 53A or second intermediate member 53B that bears the electric field. Therefore, the use of a general magnetic material for the first magnetic path 57, the use of a general dielectric material for the intermediate member, and the like are allowed, and the range of the choice of the materials is wide, so that there is an advantage in performance-vs-price.

[Relation of X = Y/N (N Is Integer)]

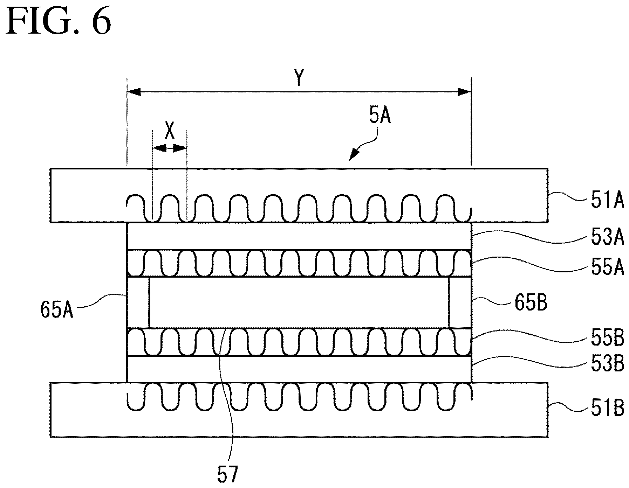

Furthermore, suppose that in the noise filter 5A, a wavelength X of the electric current that flows through the first conductive member 51A and the second conductive member 51B that constitute a portion of the transmission line is shorter than a length Y of the first conductive member 51A and the second conductive member 51B in the direction in which the electric current flows, and there is a relation of X = Y/N (N is an integer). In this case, depending on the electric currents flowing between the first conductive member 51A and the third conductive member 55A and between the second conductive member 51B and the fourth conductive member 55B, N high electric potentials and N low electric potentials (peaks and valleys) are generated. Therefore, even when the resistance members are included at both ends of between the third conductive member 55A and the fourth conductive member 55B, an electric current corresponding to the electric potential difference between the third conductive member 55A and the fourth conductive member 55B does not flow through the resistance members, and a sufficient loss cannot be obtained. This manner is shown in FIG. 6.

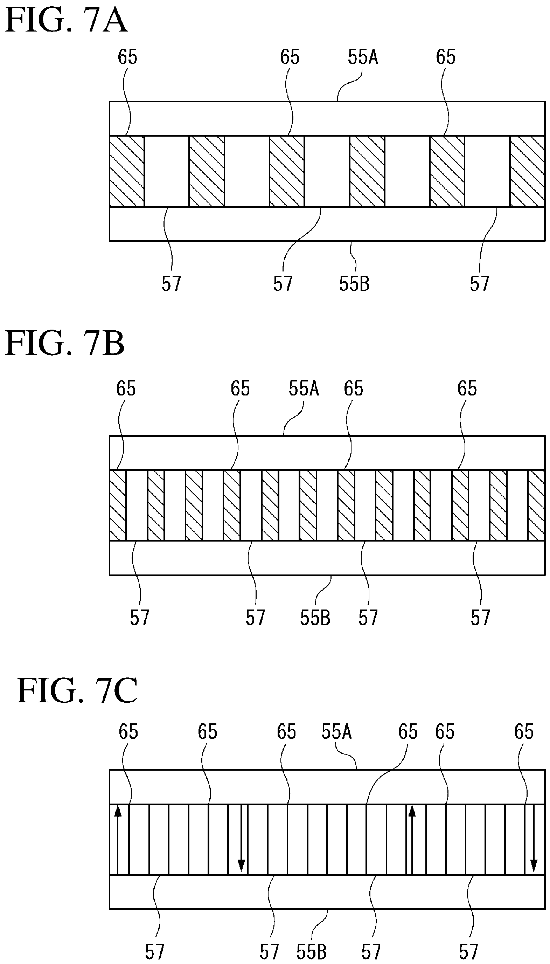

In contrast, by including 2N (even number) resistance members 65 between the third conductive member 55A and the fourth conductive member 55B in the direction of the flow of the electric current as shown in FIG. 7A and FIG. 7B, an electric current corresponding to the electric potential difference flows through the resistance members, and a sufficient loss can be obtained. Since an even number of resistance members are included, a circular circuit can be formed at any position.

The 2N resistance members do not always need to be disposed with equal gaps, and may be disposed with unequal gaps based on the distribution and fluctuation of the wavelength X of the flowing electric current. In the case where 2N is a sufficiently large value (number), the 2N individual resistors can be replaced with a single (single body) continuous resistor as a whole. This form is exemplified in FIG. 7C. That is, when 2N is a sufficiently large value and the thickness of a middle portion of the resistance member 65 and the thickness of a lead wire (not illustrated) connected to this are maximally decreased, the gap between resistance members 65 that couple the third conductive member 55A and the fourth conductive member 55B are maximally decreased. Thereby, as a whole, it is possible to configure a unified continuous resistor such as a metal lump and a conductive material lump. In FIG. 7C, arrows show orientations of the flow of the electric current.

Further, a common resistance member is a part through which electric current flows in one direction at an identical time, but in the above continuous resistor, orientations of flow of electric current at a plurality of arbitrary spots in the continuous resistor at an identical time are different from each other, and electric current can flow in two or more orientations despite a single part. The continuous resistor appears a single resistance unit, but corresponds to at least two or more resistance members because electric current flows in two or more directions.

[Replacement of Resistance Member with Impedance Circuit]

The first resistance member 65A and the second resistance member 65B are replaced with an impedance circuit, and a frequency characteristic is given to the impedance circuit. Thereby, it is possible to select, for each frequency band, a positive phase reflection of the electric current transmitted through the transmission line by increasing the impedance of the noise filter 5A according to the embodiment with respect to the characteristic impedance of the transmission line constituted by the first conductive member 51A and the second conductive member 51B, an opposite phase reflection of the electric current transmitted through the transmission line by decreasing the impedance of the noise filter 5A, or the like.

Particularly, in the case where one or both of the first resistance member 65A and the second resistance member 65B has 0 $\Omega$ or a very small resistance value, depending on the circuit characteristic of the periphery of a site where the present invention is embedded, there can be a case (Case 1) where the above series connection capacitance $C_{34}$ and the inductance $L_{56}$ of the circular conductive portion structure become main components of the impedance of the noise filter 5A and the noise filter 5A has a property as an LC resonance circuit; a case (Case 2) where a short-circuit path is provided between the third conductive member 55A and the fourth conductive member 55B and where the state between the first conductive member 51A and the third conductive member 55A and the state between the second conductive member 51B and the fourth conductive member 55B becomes electrically equivalent to short circuit; and a case (Case 3) where one of the first resistance member 65A and the second resistance member 65B becomes insulation or equivalent to insulation in the circular electric path through the third conductive member 55A, the first resistance member 65A. the fourth conductive member 55B, the second resistance member 65B, the third conductive member 55A, etc.

In the case where the above series connection capacitance $C_{34}$ and the inductance $L_{56}$ of the circular conductive portion structure become main components of the impedance of the noise filter 5A in Case 1, the noise filter 5A has the property as the LC resonance circuit, has a resonance frequency, and has the same effect as short circuit for an electric current having the same frequency as the resonance frequency.

By this effect, electric currents that are transmitted through the first conductive member 51A and the second conductive member 51B in the same direction, that have signs opposite to each other and that have the same frequency as the resonance frequency perform the short circuit between the first conductive member 51A and the second conductive member 51B. The LC resonance circuit has no resistance value, or has a very small resistance value.

Further, in the case where the short-circuit path is provided between the third conductive member 55A and the fourth conductive member 55B in Case 2, the short-circuit path is connected to the first conductive member 51A and the second conductive member 51B through the series connection capacitance $C_{34}$, and therefore, the impedance between the first conductive member 51A and the second conductive member 51B is determined mainly by the series connection capacitance $C_{34}$.

At this time, the impedance of the series connection capacitance $C_{34}$ is small for the electric current having a high frequency, and therefore, electric currents that are transmitted through the first conductive member 51A and the second conductive member 51B in the same direction, that have signs opposite to each other and that have a high frequency perform the short circuit between the first conductive member 51A and the second conductive member 51B.

In both of Case 1 and Case 2, the short-circuit current is not lost, passes by the short-circuit path, and is reflected in the opposite direction of the direction of the transmission.

Further, in the case where the resistance value of one of the first resistance member 65A and the second resistance member 65B is ∞ Ω (insulation) or a very large resistance value equal to or more than several tens times the resistance value of the third conductive member 55A and the fourth conductive member 55B in the circular electric path through the third conductive member 55A, the first resistance member 65A, the fourth conductive member 55B, the second resistance member 65B, the third conductive member 55A, etc. in Case 3, a border portion between the third conductive member 55A and the first resistance member 65A or second resistance member 65B and a border portion between the fourth conductive member 55B and the first resistance member 65A or second resistance member 65B are circuits in which electric passages are broken, and therefore, are equivalent to portions where an open end is provided at one end of either the third conductive member 55A or the fourth conductive member 55B.

Further, at the same time, the border portion between the third conductive member 55A and the first resistance member 65A or second resistance member 65B is connected to the first conductive member 51A through a series connection capacitance C1 (the first intermediate member 53A), and the impedance of the series connection capacitance C1 is small for the electric current having a high frequency. Further, the border portion between the fourth conductive member 55B and the first resistance member 65A or second resistance member 65B is connected to the second conductive member 51B through a series connection capacitance C2 (the second intermediate member 53B), and the impedance of the series connection capacitance C2 is small for the electric current having a high frequency. Therefore, for the high-frequency electric current that flows through the first conductive member 51A and the second conductive member 51B, the first conductive member 51A is equivalent to the connection with an open end through the first intermediate member 53A and the third conductive member 55A, and the second conductive member 51B is equivalent to the connection with an open end through the second intermediate member 53B and the fourth conductive member 55B. Thereby, electric currents that are transmitted through the first conductive member 51A and the second conductive member 51B in the same direction, that have signs opposite to each other and that have a high frequency are not lost, are reflected in the positive phase at the connected open ends of the first conductive member 51A and the second conductive member 51B, and are reflected in the opposite direction of the direction of the transmission through the first conductive member 51A and the second conductive member 51B.

Since the noise filter 5A according to the embodiment that equalizes an unnecessary frequency output from the inverter circuit 20, with the resonance frequency in Case 1 or the frequency of electric currents that are transmitted in the same direction and have the opposite signs in Case 2 or Case 3 is included in the output of the inverter circuit 20, it is possible to reflect the electric current having the unnecessary frequency from the output to the inverter circuit 20, and to block the transmission of the electric current having the unnecessary frequency from the inverter circuit 20 to the servomotor 3.

[Characteristic of Transmission by Noise Filter 5A, and Others]

Further, by including at least one noise filter 5A, preferably, two or more noise filters 5A on the transmission line, it is possible to achieve both the distortion-free transmission on the transmission line and the loss reduction in the electric power transmission.

The impedance of the noise filter 5A is constant as described above, and the matching with the characteristic impedance of the transmission line can be performed. Therefore, the distortion-free transmission is easy.

At low frequencies, the resistance component is not included in the impedance, and therefore, the energy of electromotive force transmission is not lost in the transmission of the electric power having low frequencies.

At high frequencies, the resistance component is included in the impedance, and therefore, the energy of the high-frequency noise included in the electric power transmission is converted into heat and is consumed, so that the noise can be removed.

In the case of the transmission line that does not include the noise filter 5A, the reflection of the transmission electric power occurs at both ends of the transmission line, and the reciprocating transmission of the transmission electric power is performed on the transmission line, so that waves of the electric power on the outward way and the return way (reflection) can become a standing wave by synthesis and the amplitude of the standing wave can increase.

The standing wave includes high-frequency electric power, and the high-frequency electric power includes noise. Therefore, the increase in the amplitude of the standing wave is synonymous with the increase in the amplitude of the noise.

Further, the impedance of the noise filter 5A is constant as described above, and the impedance matching with the transmission line is easy. In the case where noise filters 5A for which the impedance matching has been performed are included at both ends of the transmission line with a constant impedance, the reflection can be prevented at both ends of the transmission line, and therefore, it is possible to restrain the generation of the standing wave in the electric power transmission on the transmission line, and to perform the distortion-free transmission of the electric power.

It is possible to restrain the standing wave by including a plurality of noise filters 5A for the actual transmission line. The real impedance of the transmission line and noise filter 5A has an error with respect to the design value, and the impedance matching cannot be performed at a portion of the path of the transmission line including the noise filter 5A.

Particularly, in the case where the transmission line is long, it is difficult to keep a constant impedance over the whole path of the transmission line, the electric power is reflected at a spot where the impedance is not constant, and the standing wave is generated on the transmission line.

One or more sets of antinodes and nodes exist in the standing wave, and by including the noise filter 5A at a position in the transmission line that corresponds to the position of the antinode, it is possible to effectively lose the high-frequency electric power included in the standing wave, and to reduce the noise included in the high-frequency electric power.

When the electric power is supplied to the transmission line, the electric power that is transmitted through the transmission line is reflected once at each of both ends of the transmission line. In the case where the noise filter 5A is included at one end of both ends of the transmission line, the electric power that is transmitted through the transmission line is reflected once at the other end, and when the reflected electric power passes through the noise filter 5A, it is possible to lose the high-frequency electric power in the reflected electric power, and to reduce the noise included in the high-frequency electric power. Further, the position of the noise filter 5A included in the middle of the transmission line does not always need to be an end of the transmission line. The noise filter 5A may be included at the center of the transmission line, or may be included at another position. That is, the standing wave can be restrained simply by including a single noise filter 5A on the transmission line.

In the noise filter 5A, at low frequencies, the ratio of the resistance component in the impedance is small, and therefore, the energy loss in the electromotive force transmission is negligibly small in the transmission of the electric power having low frequencies.

Further, at high frequencies, the ratio of the resistance component in the impedance is large, and therefore, the energy of the high-frequency noise included in the electric power transmission is converted into heat and is lost, so that the noise can be removed.

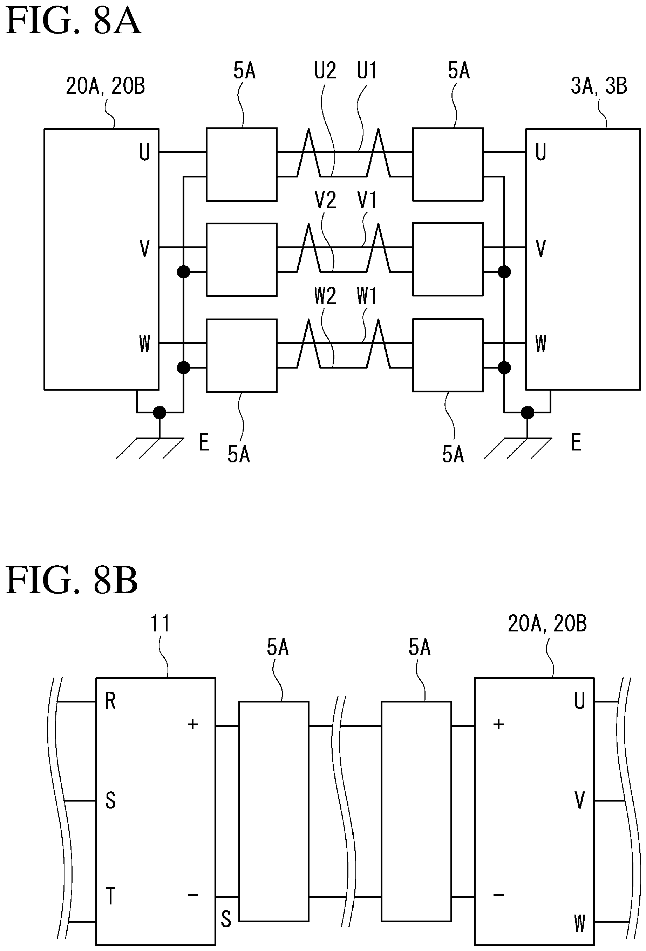

Further, in the case where the transmission line is constituted by a power wire and a pathway grounding wire E, one of the first conductive member 51A and second conductive member 51B of the noise filter 5A may be connected to the power wire, and the other may be connected to the grounding wire E. This example is shown in FIG. 8A. In this case, it is possible to prevent the reflection also in common mode noise, and to attenuate the high-frequency noise component.

Further, the position where the noise filter 5A is provided is not limited to between the inverter circuit (the first inverter circuit 20A, the second inverter circuit 20B) and the servomotor (the first servomotor 3A, the second servomotor 3B). For example, as shown in FIG. 8B, the noise filter 5A can be provided between the inverter circuit (the first inverter circuit 20A, the second inverter circuit 20B) and the rectifier 11 that rectifies commercial three-phase alternating current (R/S/T) to direct current and that supplies the direct current to the inverter circuit 20. The noise filter 5A in this case is deemed to be applied to a direct-current transmission circuit.

[Effect in Electric Motor Drive Device 10]

The electric motor drive device 10 has three pairs of transmission lines obtained by pairing respective wires in the phases of two three-phase alternating-current circuits to which mutually synchronized electric potentials in opposite phases are applied, and the three pairs of transmission lines are connected to the respective first conductive member 51A and second conductive member 51B of the noise filter 5A. Thereby, dielectricities that are equivalent to each other and that have opposite phases are generated in the third conductive member 55A and the fourth conductive member 55B. At this time, the noise included in the electric current that flows through the transmission lines has electric potentials that are equivalent and that have opposite phases, and therefore, noise components induced in the third conductive member 55A and the fourth conductive member 55B are equivalent and have opposite phases. Thereby, the noise is cancelled and lost by the third conductive member 55A, the fourth conductive member 55B, the first resistance member 65A and the second resistance member 65B, and the influence of the noise on the periphery can be prevented.

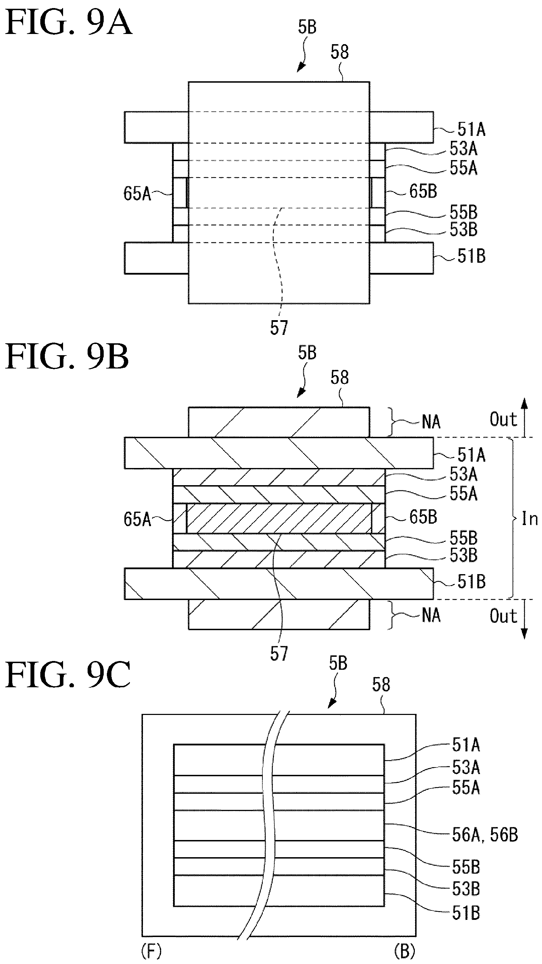

[Second Embodiment: FIGS. 9A. 9B and 9C]

Next, a noise filter 5B according to a second embodiment will be described with reference to FIG. 9A, FIG. 9B and FIG. 9C.

The noise filter 5B includes a second magnetic path 58 that surrounds outer circumferences of the first conductive member 51A, the second conductive member 51B, the third conductive member 55A, the fourth conductive member 55B, the first resistance member 65A and the second resistance member 65B. That is, as shown in FIG. 9A, FIG. 9B and FIG. 9C, the second magnetic path 58 is provided so as to contact with surfaces (outer circumference surfaces) on outsides (Out) of both of the first conductive member 51A and the second conductive member 51B. Further, as shown in FIG. 9C, the second magnetic path 58 is provided so as to contact with and cover the front end (F) and back end (B) of elements of the noise filter 5B from the first conductive member 51A to the second conductive member 51B in the width direction y. In this way, the second magnetic path 58 covers and bundles the elements of the noise filter 5B from the first conductive member 51A to the second conductive member 51B, by a circumferential path.

In the noise filter 5B having the above configuration, the second magnetic path 58 contacts with the first magnetic path 57 at the front end (F) and the back end (B), and therefore, magnetically communicate with each other. In addition, the first conductive member 51A, the second conductive member 51B, the third conductive member 55A, the fourth conductive member 55B, the first resistance member 65A, the second resistance member 65B, and the first magnetic path 57 are bundled and unified by the second magnetic path 58.

In the noise filter 5B, the second magnetic path 58 may cover both end surfaces in the length direction $\alpha$ (the right-left direction in FIG. 9A and FIG. 9B) except terminal portions of the first conductive member 51A and the second conductive member 51B for supplying electric current to the first conductive member 51A and second conductive member 51B that constitute the transmission line. That is, the second magnetic path member may also cover the end surfaces of the transmission line of the noise filter body in the direction of the flow of the electric current, which are end surfaces of the first and second intermediate members, the first and second resistance members, and the third and fourth conductive members. The same applies to noise filters 5C, 5D described later.

In the noise filter 5B, on the outsides of the two lines of the first conductive member 51A and second conductive member 51B that are the transmission line, in the case where electric currents flow through the first conductive member 51A and the second conductive member 51B in mutually opposite orientations respectively, mutually opposite magnetic fields are generated from the respective electric currents, and weaken each other, so that the intensities of the magnetic fields are reduced.

However, at a near area NA of the outside Out of one (for example, 51A) of the first conductive member 51A and the second conductive member 51B, the distance to the other conductive member (for example, 51B) is longer than the distance to the one conductive member (51A). Therefore, at the near area NA of the outside of the one conductive member (51A), the magnetic field that is generated from the other conductive member (51B) is weaker than the magnetic field that is generated from the one conductive member (51A). Therefore, even when the orientations of the magnetic fields at the near area NA are opposite, the magnetic fields are not sufficiently weakened, and the magnetic fields can influence the periphery.

Hence, the noise filter 5B includes the second magnetic path 58 that surrounds the first conductive member 51A, the second conductive member 51B, the third conductive member 55A, the fourth conductive member 55B, the first resistance member 65A and the second resistance member 65B that constitute the circuit through which the electric current causing the magnetic field flows, particularly surrounds the first conductive member 51A and the second conductive member 51B. Thereby, it is possible to hold the magnetic field in the second magnetic path 58, and to reduce the influence of magnetic field leakage on the periphery.

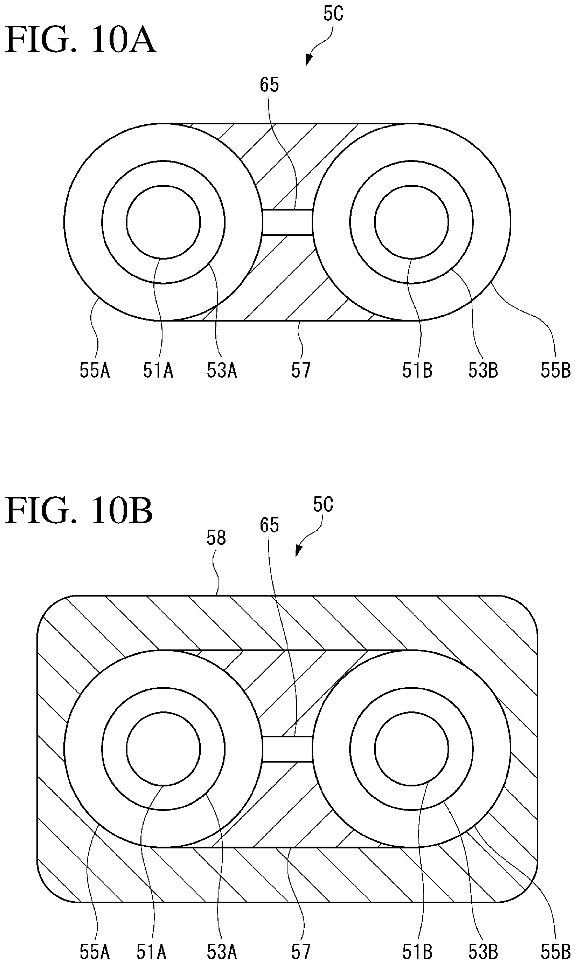

[Third Embodiment: FIGS. 10A and 10B]

Next, the noise filter 5C according to a third embodiment will be described with reference to FIG. 10A and FIG. 10B.

In the noise filter 5C, the first conductive member 51A and second conductive member 51B that are the transmission line have rod shapes, and the third conductive member 55A and the fourth conductive member 55B have tubular shapes that surround the first conductive member 51A and the second conductive member 51B respectively. By employing this structure, the magnetic field and electric field induced from the transmission line are absorbed by the third conductive member 55A and the fourth conductive member 55B, and the prevention of noise diffusion becomes easy.

Specifically, as shown in FIG. 10A, the first conductive member 51A and the second conductive member 51B are rod-shaped members, the third conductive member 55A has a tubular shape that allows the first conductive member 51A to be inserted into the third conductive member 55A, and the fourth conductive member 55B has a tubular shape that allows the second conductive member 51B to be inserted into the fourth conductive member 55B. Further, as shown in FIG. 10B, the second magnetic path 58 can be disposed so as to surround the periphery of the structure shown in FIG. 10A.

In FIG. 10A and FIG. 10B, only a single resistance member 65 is shown, but the noise filter 5C according to the third embodiment also includes a pair of resistance members 65 (that is, the first resistance member 65A and the second resistance member 65B), similarly to the noise filter 5A according to the first embodiment of the present application. That is, as can be seen from FIG. 4 (the first embodiment), which is a schematic diagram of the secondary circuit of the noise filter 5A, also in the noise filter 5C in the third embodiment, the two resistance members 65 (that is, the first resistance member 65A and the second resistance member 65B) are disposed in parallel with each other, and both of the first resistance member 65A and the second resistance member 65B disposed in parallel are disposed in series with the third conductive member 55A and the fourth conductive member 55B.

That is, even in the case where "resistance member 65" is merely written in the specification of the present application or even in the case where only a single resistance member 65 is shown as in the case of FIG. 10A and FIG. 10B, a pair of resistance members 65 (65A, 65B) is necessary for the function of the noise filter. Also in the noise filter 5C according to the third embodiment, the two resistance members 65 serve as elements of the circuit, so as to be arrayed in parallel in the direction in which the electric current flows through the transmission line.

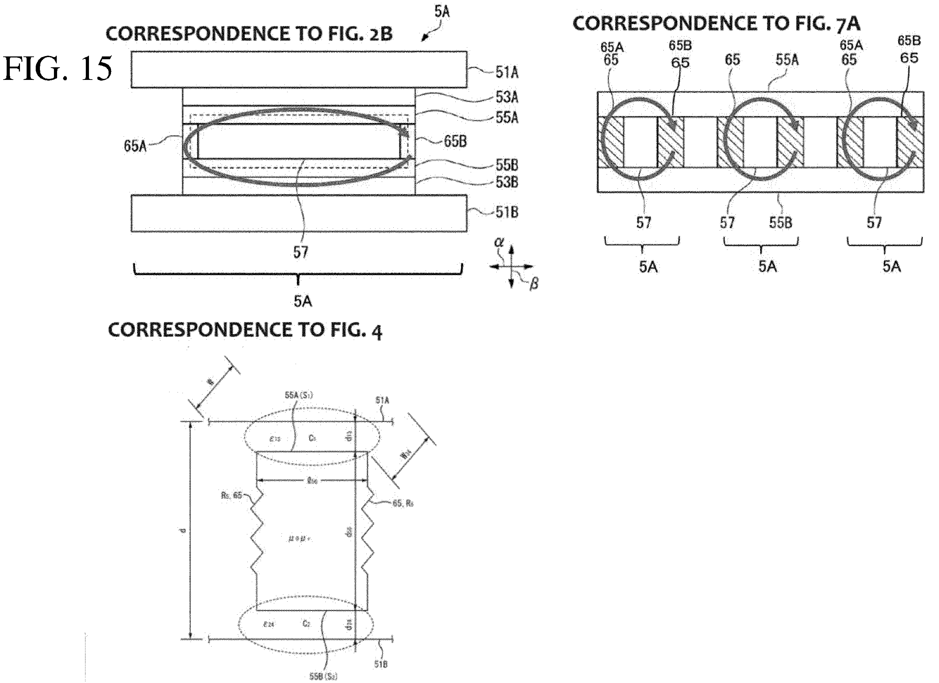

The number of resistance members 65 is not limited to two, and may be 2N (even number). By including 2N (even number) resistance numbers 65 between the third conductive member 55A and the fourth conductive member 55B in the direction of the flow of the electric current as shown in FIG. 7A and FIG. 7B, an electric current corresponding to the electric potential difference flows through the resistance members, and a sufficient loss can be obtained. Since an even number of resistance members are included, the circular circuit can be formed at any position (see a diagram in FIG. 15 that corresponds to FIG. 7A).

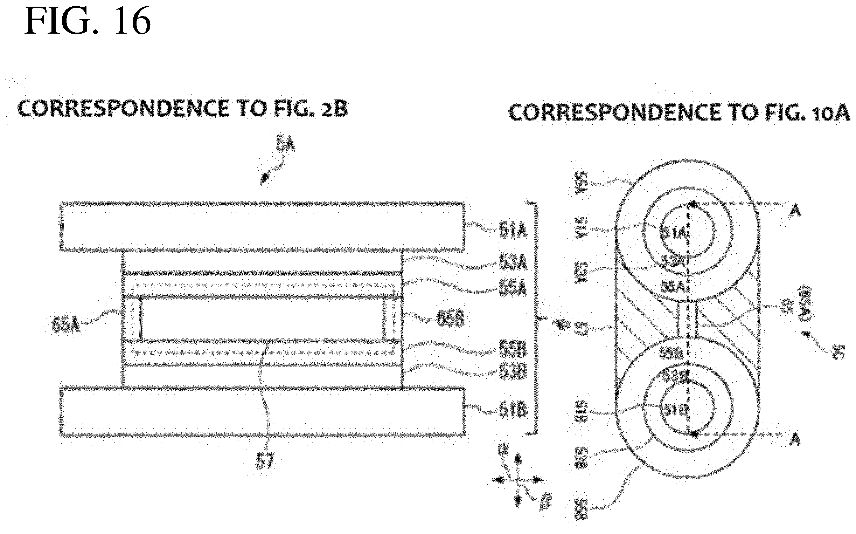

FIG. 15 and FIG. 16 are diagrams for supplemental explanation of the third embodiment.

FIG. 15 compares and shows FIG. 2B, FIG. 4 and FIG. 7A that correspond to the first embodiment. As shown by round arrows in FIG. 15, a circular electric passage is configured by the third conductive member 55A, the resistance member 65 (65B), the fourth conductive member 55B, the resistance member 65 (65A) and the third conductive member 55A.

FIG. 16 compares and shows FIG. 2B corresponding to the first embodiment and FIG. 10A corresponding to the third embodiment. In FIG. 16, a section A-A in FIG. 10A corresponds to FIG. 2B in the present application, and FIG. 10A is a diagram illustrated when FIG. 2B is viewed in the orientation of a hand arrow.

In FIG. 10A, only a single resistance member 65 is shown, but as described above, a pair of resistance members 65 is included as the noise filter 5C. As is clear from the first embodiment, one of the pair of resistance members 65 corresponds to the first resistance member 65A in FIG. 2B, and the other corresponds to the second resistance member 65B in FIG. 2B. When FIG. 2B is referred to assuming that the resistance member 65 shown in FIG. 10A is the first resistance member 65A as the one, the second resistance member 65B as the other is provided so as to be spaced apart from the first resistance member 65A in the depth direction of the sheet plane. In this case, the circular electric path in FIG. 10A is configured similarly to the circular path constituted by the third conductive member 55A, the second resistance member 65B, the fourth conductive member 55B, the first resistance member 65A and the third conductive member 55A in FIG. 2B.

The supplemental explanation with use of FIG. 15 and FIG. 16 is also applied to the noise filter 5C shown in FIG. 10B that includes the similar configuration as the noise filter 5C shown in FIG. 10A except the second magnetic path 58.

In the noise filter 5C according to the third embodiment shown in FIG. 10A, one or both of the first intermediate member 53A disposed between the first conductive member 51A and the third conductive member 55A and the second intermediate member 53B disposed between the second conductive member 51B and the fourth conductive member 55B is composed of an electrically insulating material. Consequently, even when DC is applied to between the first conductive member 51A and the second conductive member 51B, the electric current does not flow through the third conductive member 55A and the fourth conductive member 55B that are respectively insulated from the first conductive member 51A and the second conductive member 51B. Accordingly, the DC does not flow through the first resistance member 65A and the second resistance member 65B that are connected to the third conductive member 55A and the fourth conductive member 55B, and therefore, in the case of the DC application, the attenuation effect by the resistance member cannot be obtained.

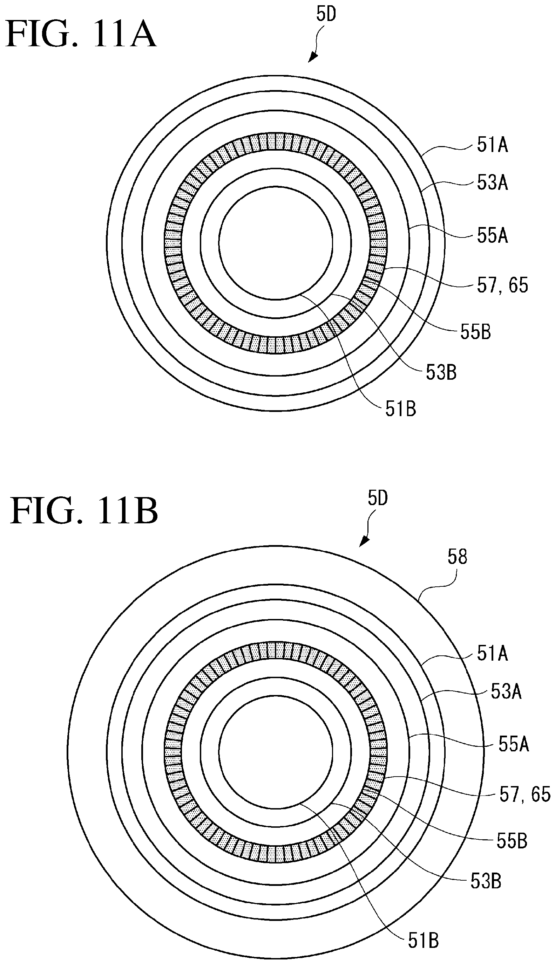

[Fourth Embodiment: FIGS. 11A and 11B]

Next, the noise filter 5D according to a fourth embodiment will be described with reference to FIG. 11A and FIG. 11B.

In the noise filter according to the fourth embodiment, all members are concentrically disposed, and thereby, it is possible to downsize the noise filter in addition to the noise diffusion prevention effect in the third embodiment.

Specifically, as shown in FIG. 11A, in the noise filter, the second conductive member 51B has a rod shape, the fourth conductive member 55B has a tubular shape that allows the second conductive member 51B to be inserted into the fourth conductive member 55B, the third conductive member 55A has a tubular shape that allows the fourth conductive member 55B to be inserted into the third conductive member 55A, and the first conductive member 51A has a tubular shape that allows the third conductive member 55A to be inserted into the first conductive member 51A.

All members constituting the noise filter 5D are not perfectly concentric, and are eccentric. In this case, the magnetic field generated by the first conductive member 51A and the magnetic field generated by the second conductive member 51B have opposite orientations on the outside of the second conductive member 51B, but do not perfectly cancel each other, and therefore, the intensities of the magnetic fields on the outside are not sufficiently reduced and the magnetic fields can influence the periphery. As shown in FIG. 11B, the second magnetic path 58 is disposed so as to surround the periphery of the structure shown in FIG. 11A. Thereby, it is possible to hold the magnetic fields on the outside in the second magnetic path 58, and to reduce the influence of the magnetic field leakage on the periphery. In this case, the first magnetic path 57 and the second magnetic path 58 do not physically communicate, but can be regarded as magnetically communicating with each other because magnetic lines go in and out between the outside and inside of the first conductive member 51A.

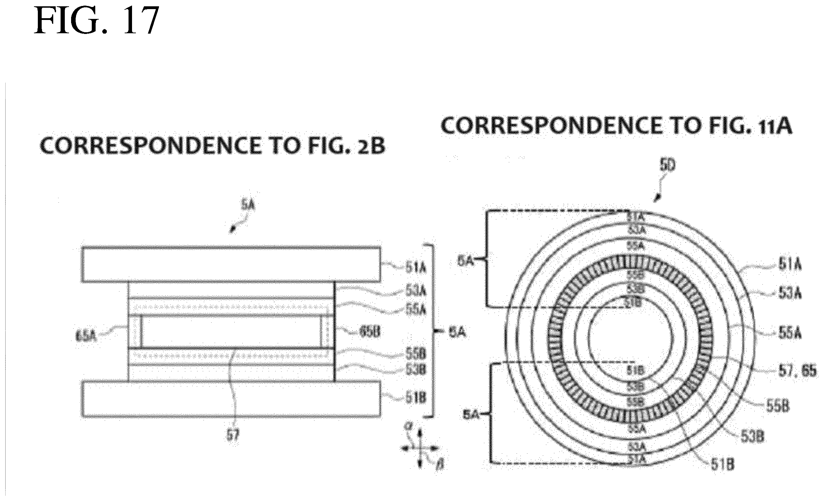

FIG. 17 is a diagram for supplemental explanation of the fourth embodiment.

FIG. 17 compares and shows FIG. 2B corresponding to the first embodiment and FIG. 11A corresponding to the fourth embodiment.

As shown in FIG. 17, the noise filter 5D in FIG. 11A corresponding to the fourth embodiment includes two noise filters each of which is the noise filter 5A shown in FIG. 2B corresponding to the first embodiment. The one corresponds to an upper half portion of the noise filter 5D in FIG. 17, and the other corresponds to a lower half portion of the noise filter 5D in FIG. 17.

In FIG. 11A, the resistance member 65 is illustrated as one cylinder together with the first magnetic path 57. As described above, the noise filter 5D includes a pair of resistance members 65, one thereof corresponds to the first resistance member 65A in FIG. 2B, and the other corresponds to the second resistance member 65B in FIG. 2B. When FIG. 2B is referred to assuming that the resistance member 65 shown in FIG. 11A is the first resistance member 65A as the one, it can be recognized that the second resistance member 65B as the other exits so as to be spaced apart from the first resistance member 65A in the depth direction orthogonal to the sheet plane. In this case, the first magnetic path 57 is disposed between the first resistance member 65A and the second magnetic path 65B. Moreover, the circular electric path in FIG. 11A is configured similarly to the third conductive member 55A, the second resistance member 65B, the fourth conductive member 55B, the first resistance member 65A and the third conductive member 55A in FIG. 2B.

That is, also in the fourth embodiment shown in FIG. 11A, "the circular electric path through the third conductive member, the first resistance member, the fourth conductive member, the second resistance member and the third conductive member" is uniquely determined to be configured in the manner of the schematic diagram of the secondary circuit of the noise filter shown in FIG. 4.

Except the second magnetic path 58, also in the noise filter 5C shown in FIG. 11B that has the similar configuration as the noise filter 5C shown in FIG. 11A, the above circular electric path is configured in the manner of the schematic diagram of the secondary circuit of the noise filter shown in FIG. 4.

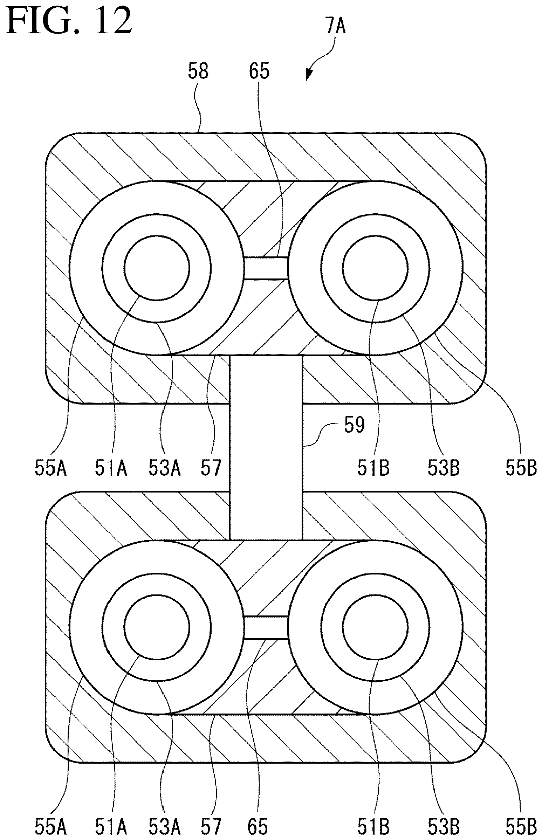

[Fifth Embodiment: FIG. 12]

Next, an integrated-type noise filter (hereinafter, an integrated noise filter) 7A according to a fifth embodiment will be described with reference to FIG. 12. The integrated noise filter 7A includes a plurality of noise filters each of which is the noise filter according to the third embodiment shown in FIG. 10B. That is, the basic configuration of the integrated noise filter 7A according to the fifth embodiment shown in FIG. 12 in the present application coincides with the noise filter 5C according to the third embodiment.

In the integrated noise filter 7A, the first magnetic paths 57 of the plurality of noise filters are joined through the third magnetic path 59 in a unified manner, and the respective second magnetic paths 58 of the plurality of noise filters are spaced apart from each other.

In the integrated noise filter 7A, the relative magnetic permeability of the third magnetic path 59 is higher than the relative magnetic permeability of the respective first magnetic paths 57 of the plurality of noise filters, in a magnetic field of 500 Hz or lower, and the relative magnetic permeability of the third magnetic path 59 is lower than the relative magnetic permeability of the respective first magnetic paths 57 of the plurality of noise filters, in a magnetic field of 1 MHz or higher.

In the case where the inverter and the motor are connected by the transmission line and the motor is driven at a high torque, a large electric current flows through the first conductive member 51A and the second conductive member 51B that are the transmission line, and a strong magnetic field is generated in the periphery of the first conductive member 51A and the second conductive member 51B. Therefore, the magnetic flux saturation can occur in the magnetic path in the periphery of the first conductive member 51A and the second conductive member 51B.

As the frequency of the electric current for driving the motor, 500 Hz or lower is generally used, and therefore, the frequency of the magnetic field that is generated from the electric current is also 500 Hz or lower, generally. Therefore, a large magnetic field that causes the magnetic flux saturation is also a low-frequency magnetic field of 500 Hz or lower.

The frequency of the electric current of the noise due to the alternating-current switching of the inverter is often 1 MHz or higher, and the frequency of the magnetic field that is generated from the electric current is also 1 MHz or higher. Therefore, a large magnetic field that causes the noise is also a high-frequency magnetic field of 1 MHz or higher.

Since the relative magnetic permeability of the third magnetic path 59 is higher than the relative magnetic permeability of each first magnetic path in the low-frequency magnetic field of 500 Hz or lower and the relative magnetic permeability of the third magnetic path 59 is lower than the relative magnetic permeability of each first magnetic path in the high-frequency magnetic field of 1 MHz or higher, it is possible to prevent the low-frequency magnetic field of 500 Hz or lower and the high-frequency magnetic field of 1 MHz or higher from concentrating at a single magnetic path. Since the magnetic field concentrates at a magnetic path having a high relative magnetic permeability, the low-frequency magnetic field of 500 Hz or lower concentrates at the third magnetic path 59, and the high-frequency magnetic field of 1 MHz or higher concentrates at the first magnetic path. Thereby, in the case of a magnetic field having a wide frequency range, the low-frequency magnetic field of 500 Hz or lower and the high-frequency magnetic field of 1 MHz or higher can be separated to the first magnetic path and the third magnetic path 59 respectively, and therefore, it is possible to prevent the magnetic field from concentrating at a single magnetic path. Consequently, it is possible to prevent the magnetic flux saturation in which the magnetic flux concentrates at a single magnetic path.

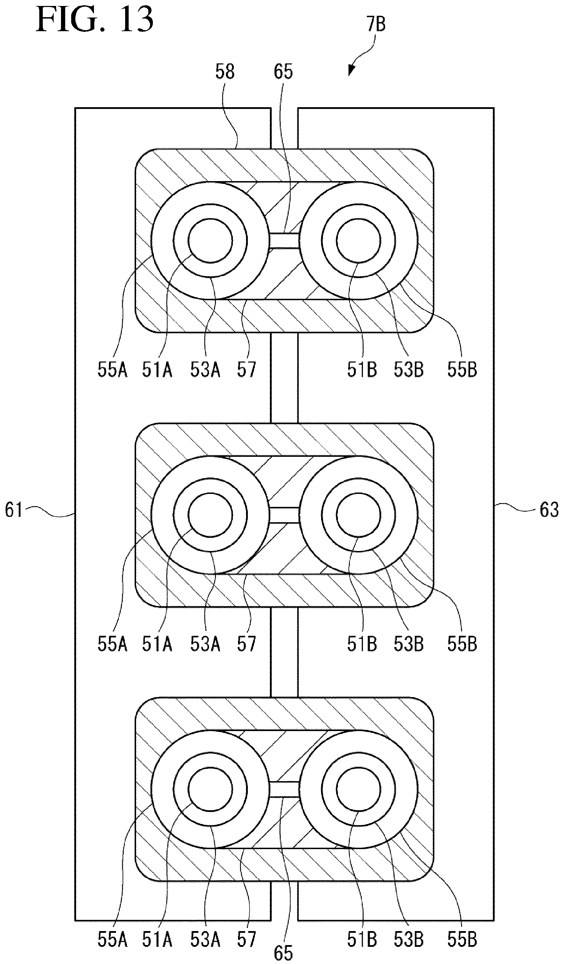

[Sixth Embodiment: FIG. 13]

Next, an integrated-type noise filter (hereinafter, an integrated noise filter) 7B according to a sixth embodiment will be described with reference to FIG. 13. The integrated noise filter 7B also includes a plurality of noise filters each of which is the noise filter according to the third embodiment shown in FIG. 10B. That is, the basic configuration of the integrated noise filter 7B according to the sixth embodiment shown in FIG. 13 in the present application coincides with the noise filter 5C according to the third embodiment.

In the integrated noise filter 7B, the respective first conductive members 51A of the plurality of noise filters are contained in a single fourth magnetic path 61, the respective second conductive members 51B of the plurality of noise filters are contained in a single fifth magnetic path 63, and the fourth magnetic path 61 and the fifth magnetic path 63 are disposed so as to be spaced apart.

In the integrated noise filter 7B, the relative magnetic permeability of the fourth magnetic path 61 and the fifth magnetic path 63 is higher than the relative magnetic permeability of the respective first magnetic paths 57 of the plurality of noise filters, in a magnetic field of 500 Hz or lower, and the relative magnetic permeability of the fourth magnetic path 61 and the fifth magnetic path 63 is lower than the relative magnetic permeability of the respective first magnetic paths 57 of the plurality of noise filters, in a magnetic field of 1 MHz or higher.

Similarly to the integrated noise filter 7A, in the integrated noise filter 7B, the low-frequency magnetic field of 500 Hz or lower and the high-frequency magnetic field of 1 MHz or higher can be separated to the first magnetic path 57 and the fourth magnetic path 61 or fifth magnetic path 63, respectively, and therefore, it is possible to prevent the magnetic field from concentrating at a single magnetic path. Consequently, it is possible to prevent the magnetic flux saturation in which the magnetic flux concentrates at a single magnetic path.

Other than the above description, without departing from the spirit of the present invention, the configurations described in the above embodiments can be optionally selected or omitted or can be altered to other configurations as appropriate.

For example, in the case where the noise filter 5 in the present invention is applied and is used as a terminating resistor, the following effects can be obtained.

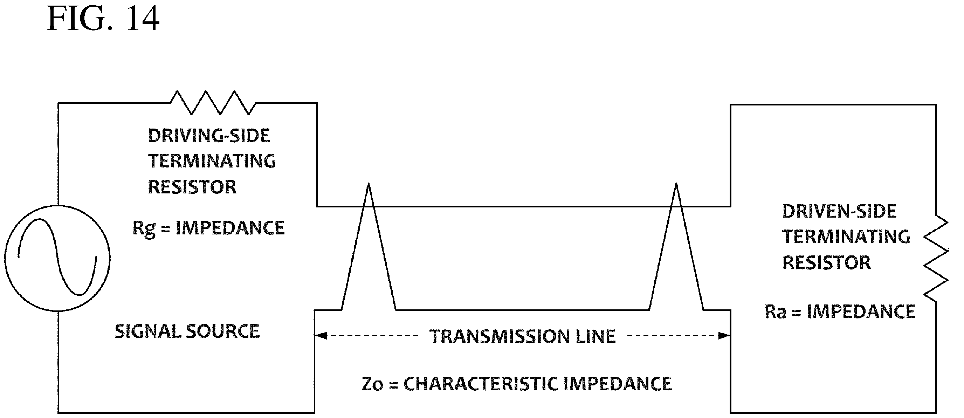

Generally, as shown in FIG. 14, in the transmission of the electric power on the transmission line, at the time of the matching of the impedance of a terminating resistor on a driving side of a signal source, the characteristic impedance of the transmission line and the impedance of a terminating resistor on a driven side, the reflection that causes an overshoot or undershoot of the waveform of the electric power that is transmitted is prevented, and the distortion-free transmission is performed.

In the distortion-free transmission, all electric power that is transmitted through the transmission line is converted into heat by the terminating resistor. All electric power includes noise, all electric energy of the noise is converted into heat by the terminating resistor, and is not radiated as electromagnetic waves, so that the influence on the periphery can be restrained.

In the case where the present invention is used as the terminating resistor, the impedance matching with the transmission line becomes easy, and therefore, it is possible to keep a constant impedance, to avoid the decrease in the electric current amount that flows through the transmission line because the impedance has no resistance component at low frequencies, and to consume and attenuate the high-frequency noise due to the resistance component included in the impedance at high frequencies. The high frequencies are frequencies equal to or higher than a noise frequency of 1 MHz that is caused by a switching frequency of 10 kHz (representative example) due to the electric power for driving the inverter, and the low frequencies are frequencies equal to or lower than 100 kHz.

Reference Signs List

1 Three-phase alternating-current power source
3 Servomotor
3A First servomotor
3B Second servomotor
5A, 5B, 5C, 5D Noise filter
7A, 7B Integrated noise filter
10 Electric motor drive device
11 Rectifier
13 Smoothing capacitor
15 Inverter main circuit
15A First inverter main circuit
15B Second inverter main circuit
16 Semiconductor switching element
16u1, 16v1, 16w1 Semiconductor switching element
16u2, 16v2, 16w2 Semiconductor switching element
16u3, 16v3, 16w3 Semiconductor switching element
16u4, 16v4, 16w4 Semiconductor switching element
17 Inverter control unit
20 Inverter circuit
20A First inverter circuit
20B Second inverter circuit
31u, 31v, 31w coil
32, 32A, 32B Stator
33 Conductor
51A First conductive member
51B Second conductive member
53A First intermediate member
53B Second intermediate member
55A Third conductive member
55B Fourth conductive member
57 First magnetic path
58 Second magnetic path
59 Third magnetic path
61 Fourth magnetic path
63 Fifth magnetic path
65A First resistance member
65B Second resistance member
T1, T2, T3 Transmission line
U1, U2 Pathway
V1, V2 Pathway
W1, W2 Pathway

**Claims**

1. A noise filter comprising:

a first conductive member and a second conductive member that constitute a transmission line;
a third conductive member that is disposed with a first intermediate member between the first conductive member and the third conductive member;
a fourth conductive member that is disposed with a second intermediate member between the second conductive member and the fourth conductive member;
a first resistance member and a second resistance member that electrically join the third conductive member and the fourth conductive member; and
a first magnetic path that is formed in a region between the third conductive member and the fourth conductive member, wherein
one or both of the first intermediate member and the second intermediate member is an insulator, and
the third conductive member, the first resistance member, the fourth conductive member, the second resistance member and the third conductive member are circularly joined to form an electric circuit.

2. The noise filter according to claim 1, further comprising a second magnetic path that is formed so as to surround outer circumferences of the first conductive member, the second conductive member, the third conductive member, the fourth conductive member, the first resistance member and the second resistance member, wherein

the first magnetic path and the second magnetic path magnetically communicate with each other, and
the first conductive member, the second conductive member, the third conductive member, the fourth conductive member, the first resistance member, the second resistance member and the first magnetic path are bundled and unified by the second magnetic path.

3. The noise filter according to claim 1 or 2, wherein
each of the first conductive member, the second conductive member, the third conductive member, the fourth conductive member, the first intermediate member and the second intermediate member has a strip shape.

4. The noise filter according to claim 1 or 2, wherein

the first conductive member and the second conductive member are rod-shaped members,
the third conductive member has a tubular shape that allows the first conductive member to be inserted into the third conductive member, and
the fourth conductive member has a tubular shape that allows the second conductive member to be inserted into the fourth conductive member.

5. The noise filter according to claim 1 or 2, wherein

the second conductive member has a rod shape,
the fourth conductive member has a tubular shape that allows the second conductive member to be inserted into the fourth conductive member,
the third conductive member has a tubular shape that allows the fourth conductive member to be inserted into the third conductive member, and
the first conductive member has a tubular shape that allows the third conductive member to be inserted into the first conductive member.

6. An electric circuit comprising three noise filters, each of the three noise filters being the noise filter according to any one of claims 1 to 5, the electric circuit having two three-phase alternating-current circuits through which electric currents flow, the electric currents being equivalent to each other, having opposite phases and being synchronized, wherein

when respective phases of one three-phase alternating-current circuit of the two three-phase alternating-current circuits are U1, V1 and W1, respective phases of the other three-phase alternating-current circuit are U2, V2 and W2, a transmission line constituted by the phase U1 and the phase U2 is a transmission line T1, a transmission line constituted by the phase V1 and the phase V2 is a transmission line T2, a transmission line constituted by the phase W1 and the phase W2 is a transmission line T3, and
the three noise filters are a noise filter A, a noise filter B and a noise filter C,
the phase U1 of the transmission line T1 is connected to the first conductive member of the noise filter A, the phase V1 of the transmission line T2 is connected to the first conductive member of the noise filter B,
the phase W1 of the transmission line T3 is connected to the first conductive member of the noise filter C, the phase U2 of the transmission line T1 is connected to the second conductive member of the noise filter A,
the phase V2 of the transmission line T2 is connected to the second conductive member of the noise filter B, and the phase W2 of the transmission line T3 is connected to the second conductive member of the noise filter C.

7. An integrated-type noise filter comprising a plurality of noise filters, each of the plurality of noise filters being the noise filter according to claim 2, wherein

the first magnetic paths of the plurality of noise filters are joined through a third magnetic path in a unified manner,
the respective second magnetic paths of the plurality of noise filters are spaced apart from each other,
a relative magnetic permeability of the third magnetic path is higher than a relative magnetic permeability of the respective first magnetic paths of the plurality of noise filters, in a magnetic field of 500 Hz or lower, and

the relative magnetic permeability of the third magnetic path is lower than the relative magnetic permeability of the respective first magnetic paths of the plurality of noise filters, in a magnetic field of 1 MHz or higher.

8. An integrated-type noise filter comprising a plurality of noise filters, each of the plurality of noise filters being the noise filter according to claim 2, wherein

the respective first conductive members of the plurality of noise filters are contained in a single fourth magnetic path, the respective second conductive members of the plurality of noise filters are contained in a single fifth magnetic path, and the fourth magnetic path and the fifth magnetic path are disposed so as to be spaced apart, a relative magnetic permeability of the fourth magnetic path and the fifth magnetic path is higher than a relative magnetic permeability of the respective first magnetic paths of the plurality of noise filters, in a magnetic field of 500 Hz or lower, and
the relative magnetic permeability of the fourth magnetic path and the fifth magnetic path is lower than the relative magnetic permeability of the respective first magnetic paths of the plurality of noise filters, in a magnetic field of 1 MHz or higher.

9. The noise filter according to any one of claims 1 to 5, wherein
a circular electric circuit through the third conductive member, the first resistance member, the fourth conductive member, the second resistance member and the third conductive member is formed in a length direction of the transmission line.

10. The noise filter according to any one of claims 1 to 5, wherein
both of the first intermediate member and the second intermediate member are insulators.

**Amended claims under Art. 19.1 PCT**

1. A noise filter comprising:

a first conductive member and a second conductive member that constitute a transmission line;
a third conductive member that is disposed with a first intermediate member between the first conductive member and the third conductive member;
a fourth conductive member that is disposed with a second intermediate member between the second conductive member and the fourth conductive member;
a first resistance member and a second resistance member that electrically join the third conductive member and the fourth conductive member; and
a first magnetic path that is formed in a region between the third conductive member and the fourth conductive member, wherein
one or both of the first intermediate member and the second intermediate member is an insulator, and
the third conductive member, the first resistance member, the fourth conductive member, the second resistance member and the third conductive member are circularly joined to form a circular electric circuit, wherein the circular electric circuit through the third conductive member, the first resistance member, the fourth conductive member, the second resistance member and the third conductive member is formed in a length direction of the transmission line.

2. The noise filter according to claim 1, further comprising a second magnetic path that is formed so as to surround outer circumferences of the first conductive member, the second conductive member, the third conductive member, the fourth conductive member, the first resistance member and the second resistance member, wherein

the first magnetic path and the second magnetic path magnetically communicate with each other, and
the first conductive member, the second conductive member, the third conductive member, the fourth conductive member, the first resistance member, the second resistance member and the first magnetic path are bundled and unified by the second magnetic path.

3. The noise filter according to claim 1 or 2, wherein
each of the first conductive member, the second conductive member, the third conductive member, the fourth conductive member, the first intermediate member and the second intermediate member has a strip shape.

4. The noise filter according to claim 1 or 2, wherein

the first conductive member and the second conductive member are rod-shaped members,
the third conductive member has a tubular shape that allows the first conductive member to be inserted into the third conductive member, and
the fourth conductive member has a tubular shape that allows the second conductive member to be inserted into the fourth conductive member.

5. The noise filter according to claim 1 or 2, wherein

the second conductive member has a rod shape,
the fourth conductive member has a tubular shape that allows the second conductive member to be inserted into the fourth conductive member,
the third conductive member has a tubular shape that allows the fourth conductive member to be inserted into the third conductive member, and
the first conductive member has a tubular shape that allows the third conductive member to be inserted into the first conductive member.

6. An electric circuit comprising three noise filters, each of the three noise filters being the noise filter according to any one of claims 1 to 5, the electric circuit having two three-phase alternating-current circuits through which electric currents flow, the electric currents being equivalent to each other, having opposite phases and being synchronized, wherein

when respective phases of one three-phase alternating-current circuit of the two three-phase alternating-current circuits are U1, V1 and W1, respective phases of the other three-phase alternating-current circuit are U2, V2 and W2, a transmission line constituted by the phase U1 and the phase U2 is a transmission line T1, a transmission line constituted by the phase V1 and the phase V2 is a transmission line T2, a transmission line constituted by the phase W1 and the phase W2 is a transmission line T3, and
the three noise filters are a noise filter A, a noise filter B and a noise filter C,
the phase U1 of the transmission line T1 is connected to the first conductive member of the noise filter A, the phase V1 of the transmission line T2 is connected to the first conductive member of the noise filter B,
the phase W1 of the transmission line T3 is connected to the first conductive member of the noise filter C, the phase U2 of the transmission line T1 is connected to the second conductive member of the noise filter A,
the phase V2 of the transmission line T2 is connected to the second conductive member of the noise filter B,
and the phase W2 of the transmission line T3 is connected to the second conductive member of the noise filter C.

7. An integrated-type noise filter comprising a plurality of noise filters, each of the plurality of noise filters being the noise filter according to claim 2, wherein

the first magnetic paths of the plurality of noise filters are joined through a third magnetic path in a unified manner,
the respective second magnetic paths of the plurality of noise filters are spaced apart from each other,
a relative magnetic permeability of the third magnetic path is higher than a relative magnetic permeability of the respective first magnetic paths of the plurality of noise filters, in a magnetic field of 500 Hz or lower, and
the relative magnetic permeability of the third magnetic path is lower than the relative magnetic permeability of the respective first magnetic paths of the plurality of noise filters, in a magnetic field of 1 MHz or higher.

8. An integrated-type noise filter comprising a plurality of noise filters, each of the plurality of noise filters being the noise filter according to claim 2, wherein

the respective first conductive members of the plurality of noise filters are contained in a single fourth magnetic path, the respective second conductive members of the plurality of noise filters are contained in a single fifth magnetic path, and the fourth magnetic path and the fifth magnetic path are disposed so as to be spaced apart,
a relative magnetic permeability of the fourth magnetic path and the fifth magnetic path is higher than a relative magnetic permeability of the respective first magnetic paths of the plurality of noise filters, in a magnetic field of 500 Hz or lower, and
the relative magnetic permeability of the fourth magnetic path and the fifth magnetic path is lower than the relative magnetic permeability of the respective first magnetic paths of the plurality of noise filters, in a magnetic field of 1 MHz or higher.

9. The noise filter according to any one of claims 1 to 5, wherein
   both of the first intermediate member and the second intermediate member are insulators.

FIG. 1

EP 4 432 561 A1

# FIG. 2A

5A

(F)                                                                    (B)

51A

65A

51B

53A  55A

65B

53B  55B  57

α
β
γ

# FIG. 2B

5A

51A
53A
55A

65A                                                65B

55B
53B

51B

57

α
β

FIG. 3A

FIG. 3B

FIG. 3C

# FIG. 4

# FIG. 5

5A

L (EQUIVALENCE TO 1 TURN COIL)

$C_1$ (USE OF FLOATING CAPACITANCE)

MAGNETIC SUBSTANCE

$R_5$

$R_6$

$C_2$ (USE OF FLOATING CAPACITANCE)

L (EQUIVALENCE TO 1 TURN COIL)

# FIG. 6

FIG. 7A

FIG. 7B

FIG. 7C

FIG. 8A

FIG. 8B

FIG. 9A

5B
58

51A
53A
55A

65A
65B

55B
53B
51B

57

FIG. 9B

5B
58

NA

Out ↑

51A
53A
55A

65A
65B

In

55B
53B
51B

NA

Out ↓

57

FIG. 9C

5B
58

51A
53A
55A

56A, 56B

55B
53B
51B

(F)
(B)

FIG. 10A

5C

65

55A   51A   53A   57   51B   53B   55B

FIG. 10B

58   65   5C

55A   51A   53A   57   51B   53B   55B

FIG. 11A

5D

51A
53A
55A
57, 65
55B
53B
51B

FIG. 11B

5D

58

51A
53A
55A
57, 65
55B
53B
51B

# FIG. 12

7A

58    65

55A    51A    53A    57    59    51B    53B    55B

55A    51A    53A    57    65    51B    53B    55B

# FIG. 13

# FIG. 14

DRIVING-SIDE
TERMINATING
RESISTOR

Rg = IMPEDANCE

SIGNAL SOURCE

DRIVEN-SIDE
TERMINATING
RESISTOR

Ra = IMPEDANCE

TRANSMISSION LINE

Zo = CHARACTERISTIC IMPEDANCE

EP 4 432 561 A1

FIG. 15

CORRESPONDENCE TO FIG. 2B

CORRESPONDENCE TO FIG. 7A

CORRESPONDENCE TO FIG. 4

EP 4 432 561 A1

# FIG. 16

CORRESPONDENCE TO FIG. 2B

CORRESPONDENCE TO FIG. 10A

# FIG. 17

CORRESPONDENCE TO FIG. 2B

CORRESPONDENCE TO FIG. 11A

EP 4 432 561 A1

## INTERNATIONAL SEARCH REPORT

| International application No. |
| --- |
| **PCT/JP2022/041015** |

| A. | CLASSIFICATION OF SUBJECT MATTER |
| --- | --- |

*H03H 7/075*(2006.01)i; *H01F 37/00*(2006.01)i; *H03H 7/06*(2006.01)i
FI: H03H7/075 A; H03H7/06; H01F37/00 N; H01F37/00 R

According to International Patent Classification (IPC) or to both national classification and IPC

| B. | FIELDS SEARCHED |
| --- | --- |

Minimum documentation searched (classification system followed by classification symbols)

H03H7/075; H01F37/00; H03H7/06

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2014-87107 A (NISSAN MOTOR CO LTD) 12 May 2014 (2014-05-12) paragraphs [0010]-[0085], fig. 1-16 | 1-10 |
| A | JP 2010-193190 A (I CAST KK) 02 September 2010 (2010-09-02) paragraphs [0106]-[0109], [0178]-[0190], fig. 1-2, 6-19 | 1-10 |
| A | JP 2005-123751 A (SANWA DENKI KK) 12 May 2005 (2005-05-12) paragraphs [0013]-[0053], fig. 1-28 | 1-10 |
| A | JP 2002-84157 A (KOA CORP) 22 March 2002 (2002-03-22) paragraphs [0015]-[0030], fig. 1-14 | 1-10 |
| A | JP 10-70429 A (ALPS ELECTRIC CO LTD) 10 March 1998 (1998-03-10) paragraphs [0002]-[0003], fig. 8(a)-8(b) | 1-10 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **18 January 2023** | **31 January 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

| | International application No. |
|---|---|
| | **PCT/JP2022/041015** |

| Patent document cited in search report | | | Publication date (day/month/year) | Patent family member(s) | Publication date (day/month/year) |
|---|---|---|---|---|---|
| JP | 2014-87107 | A | 12 May 2014 | (Family: none) | |
| JP | 2010-193190 | A | 02 September 2010 | (Family: none) | |
| JP | 2005-123751 | A | 12 May 2005 | (Family: none) | |
| JP | 2002-84157 | A | 22 March 2002 | (Family: none) | |
| JP | 10-70429 | A | 10 March 1998 | (Family: none) | |

Form PCT/ISA/210 (patent family annex) (January 2015)

**EP 4 432 561 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000244271 A
- JP 56006423 A
- JP 2268506 A